(19)

Europäisches Patentamt
European Patent Office
Office européen des brevets

(11) EP 3 492 941 A1

(12) **EUROPEAN PATENT APPLICATION**
published in accordance with Art. 153(4) EPC

(43) Date of publication:
05.06.2019 Bulletin 2019/23

(21) Application number: 17834509.6

(22) Date of filing: 27.07.2017

(51) Int Cl.:
$G01R\ 33/387^{(2006.01)}$　　$G01R\ 33/3815^{(2006.01)}$
$H01F\ 6/00^{(2006.01)}$　　$H01F\ 6/04^{(2006.01)}$
$H01F\ 13/00^{(2006.01)}$

(86) International application number:
PCT/JP2017/027348

(87) International publication number:
WO 2018/021507 (01.02.2018 Gazette 2018/05)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 27.07.2016 JP 2016147154

(71) Applicant: **Nippon Steel & Sumitomo Metal Corporation**
**Tokyo 100-8071 (JP)**

(72) Inventor: **MORITA, Mitsuru**
**Tokyo 100-8071 (JP)**

(74) Representative: **Vossius & Partner**
**Patentanwälte Rechtsanwälte mbB**
**Siebertstrasse 3**
**81675 München (DE)**

(54) **BULK MAGNET STRUCTURE, MAGNET SYSTEM FOR NMR USING SAID BULK MAGNET STRUCTURE, AND MAGNETIZATION METHOD FOR BULK MAGNET STRUCTURE**

(57)　In the present invention, a non-uniform applied magnetic field is used to magnetize a bulk magnet structure with a magnetic field having high uniformity. Provided is a bulk magnet structure that comprises at least one ring-shaped oxide superconducting bulk body, that is configured by layering ring-shaped oxide superconducting bulk bodies or columnar oxide superconducting bulk bodies, and that has fitted thereto at least one outer circumferential reinforcing ring covering the outer circumferential surface of the bulk magnet structure. Also provided is a magnetization method for a bulk magnet structure including a basic magnetization step in which the strength of a magnetic field applied to the aforementioned bulk magnet structure is decreased while the bulk magnet structure is held in a superconducting state by a temperature controller. After the basic magnetization step, the bulk magnet structure is magnetized by controlling at least one of the temperature controller and a magnetic field generator so that a uniform magnetic field area is obtained in which the magnetic field distribution of at least a partial area in the axial direction of the bulk magnet structure is more uniform than the distribution of the applied magnetic field prior to magnetization.

FIG. 3B

**Description**

FIELD

The present invention relates to a bulk magnet structure and a magnetization method for the bulk magnet structure, and more particularly to a bulk magnet structure that is magnetized using a nonuniform static magnetic field to obtain a more uniform magnetic field, a magnet system for NMR using the bulk magnet structure and a magnetization method for the bulk magnet structure.

BACKGROUND

An oxide superconducting bulk body (so-called QMG (registered trademark) bulk body) in which $RE_2BaCuO_5$ phase is dispersed in a monocrystalline $REBa_2Cu_3O_{7-x}$ (RE is a rare earth element) phase has a high critical current density (hereinafter also referred to as "Jc"). Therefore, it can be used as a superconducting bulk magnet excited by cooling in a magnetic field or pulse magnetization and capable of generating a strong magnetic field.

Examples of application fields requiring a strong magnetic field include NMR (Nuclear Magnetic Resonance) and MRI (Magnetic Resonance Imaging). A superconducting bulk magnet to be used for both application fields is required to have a strong magnetic field of several T and high uniformity on the order of ppm.

With respect to NMR application using an oxide superconducting bulk body, there are applications to small (for example, desktop) NMR described in, for example, Patent Documents 1 to 6 and Non-Patent Documents 1 and 2. The fundamental technical ideas of these small NMR applications are as follows. Conventional superconducting magnets for NMR used as magnetizing magnets use superconducting wires, are relatively large, have high uniformity on the order of ppm, and can generate high strength magnetic fields. Inside the room temperature bore of the conventional superconducting magnet for NMR, a bulk magnet structure formed by layering a plurality of ring-shaped oxide superconducting bulk bodies is disposed. By cooling this bulk magnet structure to a superconducting state in a highly uniform magnetic field and then removing the applied magnetic field, the uniform magnetic field generated by the conventional superconducting magnet for NMR is copied to the bulk magnet structure.

In application to such a small NMR, a superconducting magnet for NMR of a wide bore (room temperature bore diameter of 89 mm) is usually used. Accordingly, in combination with it, a ring-shaped oxide superconducting bulk body having an outer diameter of about 60 mm and an inner diameter of about 30 mm is used. In this case, the magnetization temperature is considerably low, on the order of 40 K, and magnetization is performed under conditions that sufficiently high critical current density (Jc) can be obtained. Specifically, the superconducting current in the cross section of the ring-shaped oxide superconducting bulk body is not in the state of flowing through the entire cross-section (fully magnetized state) but in a state where the superconducting current flows only partially (non-fully magnetized state). By doing so, it is possible to copy a strong magnetic field in the NMR superconducting magnet with a margin. Furthermore, after magnetization, in order to ensure the temporal stability of the magnetic field copied into the ring-shaped oxide superconducting bulk body, the magnet is further cooled from the magnetization temperature to obtain a magnet for small NMR.

Focusing attention on the magnetization methods of Patent Documents 1 to 6 and Non-Patent Documents 1 and 2, for example, Patent Document 1 discloses a method for pulse magnetization and static magnetic field magnetization in an NMR system having a bulk magnet in which ring-shaped oxide superconducting bulk bodies are layered. Patent Document 2 discloses a magnetization method using an NMR system having a bulk magnet in which ring-shaped oxide superconducting bulk bodies are layered such that the magnetic field strength distribution in the central portion has a magnetic field distribution which is either upwardly convex or downwardly convex. When the magnetic field distribution is upwardly convex, the magnetic field strength becomes a peak at the vertex of the convex, and when the magnetic field distribution is downwardly convex, the magnetic field strength becomes a minimum at the vertex of the convex.

Further, Patent Document 3 and Non-Patent Document 1 describe a magnetization method by applying a uniform static magnetic field. In such a magnetization method, a superconducting magnetic field generator having a tubular superconducting body formed by coaxially arranging tubular superconducting bulks having a small magnetic susceptibility on both end faces of a tubular superconducting bulk having a high magnetic susceptibility is used. For example, according to the superconducting magnetic field generator disclosed in Patent Document 3, by designing the magnetic susceptibility and shape of the superconducting bulk so as to satisfy certain conditions, a captured magnetic field having a uniform magnetic field strength in the axial direction of the superconducting body can be formed in the bore of the superconducting body.

Patent Document 4 discloses a superconducting magnetic field generator having a correction coil disposed around a superconducting body made of a tubular superconducting bulk. According to such a superconducting magnetic field generator, when applying a magnetic field to the superconducting body to magnetize it, the applied magnetic field is corrected by the correction coil, whereby a captured magnetic field having a uniform magnetic field strength in the axial direction of the superconducting body can be formed in the bore of the superconducting body.

Patent Document 5 discloses a superconducting magnetic field generator having a superconducting body formed in a tubular shape such that the inner diameter of the center portion in the axial direction is larger than the inner diameter of the end portion. According to such a superconducting magnetic field generator, by setting the inner diameter of the center portion in the axial direction of the tubular superconducting body to be larger than the inner diameter of the end portion, the magnetic field that cancels out the nonuniform magnetic field generated by the magnetization of the superconducting body is formed in the bore of the superconducting body. In Patent Document 5, it is considered that a captured magnetic field having a uniform magnetic field strength in the axial direction of the superconducting body can be formed in the bore of the superconducting body by removing the nonuniform magnetic field in this way. Magnetization in Patent Document 5 is performed by inserting a high temperature superconducting body into a uniform magnetic field and then making it capture the magnetic field by cooling it to a temperature below its superconducting transition temperature. In addition, Patent Document 5 discloses that it is difficult to obtain a uniform magnetic field only with a high-temperature superconducting body and it is necessary to arrange a correction coil in a space inside a tube of a high-temperature superconducting body.

In Patent Document 6 and Non-Patent Document 2, a magnetization method for obtaining a uniform magnetic field by inserting a tube in which a tape wire material having a high critical current density Jc is spirally wound into a bulk magnet in which ring-shaped oxide superconducting bulk bodies are layered, thereby cancelling the magnetic field component perpendicular to the axial direction.

On the other hand, in application to a small NMR, very strong magnetic field is confined in the compact space of the bulk magnet structure. For this reason, a large electromagnetic stress acts inside the superconducting bulk body. This electromagnetic stress is also called "a hoop stress" because it acts to spread the confined magnetic field. In the case of a strong magnetic field of 5 to 10 T class, the electromagnetic stress may exceed the material mechanical strength of the superconducting bulk body itself. As a result, the superconducting bulk body may break. If the superconducting bulk body breaks, the superconducting bulk body cannot generate a strong magnetic field.

In order to prevent breakage of the superconducting bulk body due to such electromagnetic force, for example, Patent Document 7 discloses that a superconducting bulk magnet is constituted by a columnar superconducting bulk body and a metal ring surrounding the superconducting bulk body. By adopting such a configuration, compressive stress by the metal ring is applied to the superconducting bulk body at the time of cooling, and the compressive stress has an effect of reducing the electromagnetic stress. Therefore, cracking of the superconducting bulk body can be suppressed. Thus, Patent Document 7 shows that breakage of the columnar superconducting bulk body can be prevented.

As another configuration example of the superconducting bulk body for preventing the breakage of the superconducting bulk body, for example, Patent Document 8 discloses a superconducting magnetic field generator in which seven hexagonal superconducting bulk bodies are combined, a reinforcing member made of a fiber reinforced resin or the like is disposed around them, and a support member made of a metal such as stainless steel or aluminum is disposed on the outer circumference of the reinforcing member. Patent Document 9 discloses an oxide superconducting bulk magnet in which ring-shaped bulk superconducting bodies having a thickness in the c-axis direction of the crystal axis of 0.3 to 15 mm are layered. Patent Document 10 discloses a superconducting bulk magnet in which a plurality of ring-shaped superconducting bodies having reinforced outer and inner circumferences are layered. Patent Document 11 discloses a superconducting bulk magnet in which superconducting bodies having a multiple ring structure in the radial direction are layered. Patent Document 12 discloses a bulk magnet in which the outer circumference and the upper and lower surfaces of one bulk body are reinforced.

[PRIOR ART DOCUMENT]

[PATENT DOCUMENT]

[Patent Document 1] Japanese Unexamined Patent Publication (Kokai) No. 2002-006021
[Patent Document 2] Japanese Unexamined Patent Publication (Kokai) No. 2007-129158
[Patent Document 3] Japanese Unexamined Patent Publication (Kokai) No. 2008-034692
[Patent Document 4] Japanese Unexamined Patent Publication (Kokai) No. 2009-156719
[Patent Document 5] Japanese Unexamined Patent Publication (Kokai) No. 2014-053479
[Patent Document 6] Japanese Unexamined Patent Publication (Kokai) No. 2016-6825
[Patent Document 7] Japanese Unexamined Patent Publication (Kokai) No. 11-335120
[Patent Document 8] Japanese Unexamined Patent Publication (Kokai) No. 11-284238
[Patent Document 9] Japanese Unexamined Patent Publication (Kokai) No. 10-310497
[Patent Document 10] Japanese Unexamined Patent Publication (Kokai) No. 2014-75522
[Patent Document 11] International Publication WO 2011/071071

[Patent Document 12] Japanese Unexamined Patent Publication (Kokai) No. 2014-146760

[NON-PATENT DOCUMENT]

[Non-Patent Document 1] Takashi Nakamura et al: Low Temperature Engineering Vol. 46, No. 3,2011
[Non-Patent Document 2] Hiroyuki Fujishiro et al; Supercond. Sci. Technol. 28 (2015) 095018

SUMMARY

[PROBLEMS TO BE SOLVED BY THE INVENTION]

However, these Patent Documents 1 to 12 and Non-Patent Documents 1 and 2 do not describe a bulk magnet structure capable of being uniformly magnetized using a nonuniform static magnetic field, and a magnetization method of the bulk magnet structure.
The present invention has been made in view of the above problems, and the object of the present invention is to provide a bulk magnet structure capable of being magnetized in a manner having a more uniform magnetic field, even using a nonuniform applied magnetic field, and to provide a magnetization method thereof. The object of the present invention is to provide a bulk magnet structure capable of preventing breakage of the superconducting bulk body having a structure necessary for this magnetization method and even under high magnetic field strength condition. Furthermore, the object is to provide a bulk magnet structure having a uniform magnetic field for NMR, and to provide an NMR magnet system using this bulk magnet structure.

[MEANS FOR SOLVING THE PROBLEMS]

As a result of intensive studies, the inventors found that the magnetic field after magnetization can be made uniform by changing an inner diameter of the bulk magnet structure in the axial direction according to a nonuniform static magnetic field. Since the bulk magnet structure is generally constructed by layering ring shaped oxide superconducting bulk bodies, by combining ring-shaped oxide superconducting bulk bodies having different inner diameters, a bulk magnet structure having an appropriate distribution of the inner diameters in the axial direction can be obtained.
The change in inner diameters of the bulk magnet structure in the axial direction can be achieved by make an inner diameter of at least one of the ring-shaped oxide superconducting bulk bodies larger than that of the adjacent ring-shaped oxide superconducting bulk body.
In addition, in order to solve the above problems, according to another aspect of the present invention, there is provided a bulk magnet structure comprising a plurality of ring-shaped oxide superconducting bulk bodies and at least one outer circumferential reinforcing ring fitted to cover the outer circumferential surface of said plurality of the layered ring-shaped oxide superconducting bulk bodies, wherein at least one of the ring-shaped oxide superconducting bulk body has an inner diameter that is larger than an inner diameter of a ring-shaped oxide superconductive bulk body adjacent to the above oxide superconductive bulk body.
The inner diameter of the central oxide superconducting bulk body located at the central portion in the layered direction of the ring-shaped oxide superconducting bulk bodies may be larger than the inner diameter of the ring-shaped oxide superconducting bulk body adjacent to the central oxide superconducting bulk body.
The height in the layered direction (Z-axis direction) of the ring-shaped oxide superconducting bulk body whose inner diameter is larger than the inner diameter of the adjacent ring-shaped oxide superconducting bulk body may be 10 mm to 30 mm.
In the bulk magnet structure, a columnar oxide superconducting bulk body may be further layered.
A columnar oxide superconducting bulk body may be disposed at one of the ends in the layered direction of the bulk magnet structure.
Further, in order to solve the above problems, according to another aspect of the present invention, there is provided a bulk magnet structure comprising a plurality of ring-shaped oxide superconducting bulk bodies and at least one outer circumferential reinforcing ring fitted to cover the outer circumferential surface of said plurality of the layered ring-shaped oxide superconducting bulk bodies, wherein at least one of the ring-shaped oxide superconducting bulk body forms a stack in which a ring-shaped oxide superconducting bulk body and a first planar ring are alternately arranged.
The inner diameter of at least one ring-shaped oxide superconducting bulk body may be larger than the inner diameter of the ring-shaped oxide superconducting bulk body adjacent to the above oxide superconducting bulk body.
The inner diameter of the central oxide superconducting bulk body located at the central portion in the layered direction of the ring-shaped oxide superconducting bulk bodies may be larger than the inner diameter of the ring-shaped oxide superconducting bulk body adjacent to the central oxide superconducting bulk body.

The height in the layered direction (Z-axis direction) of the ring-shaped oxide superconducting bulk body whose inner diameter is larger than the inner diameter of the adjacent ring-shaped oxide superconducting bulk body may be 10 mm to 30 mm.

In the bulk magnet structure, a columnar oxide superconducting bulk body may be further layered.

A columnar oxide superconducting bulk body may be disposed at one of the ends in the layered direction of the bulk magnet structure.

The thickness of the ring-shaped oxide superconducting bulk body constituting the stack with the first planar ring is preferably 5 mm or less.

Further, in order to solve the above problems, according to another aspect of the present invention, there is provided a bulk magnet structure comprising a plurality of oxide superconducting bulk bodies and at least one outer circumferential reinforcing ring fitted to cover the outer circumferential surface of said plurality of the layered oxide superconducting bulk bodies, wherein said plurality of oxide superconducting bulk bodies comprise at least one ring-shaped oxide superconducting bulk body, and are configured by layering the ring-shaped oxide superconducting bulk body or a columnar oxide superconducting bulk body, wherein at least one of the oxide superconducting bulk body forming the bulk magnet structure forms a stack in which a ring-shaped oxide superconducting bulk body and a second planar ring are alternately arranged, and the second planar ring is made of a metal.

The inner diameter of at least one ring-shaped oxide superconducting bulk body may be larger than the inner diameter of a ring-shaped oxide superconducting bulk body adjacent to the above oxide superconducting bulk body.

The inner diameter of the central oxide superconducting bulk body located at the central portion in the layered direction of the ring-shaped oxide superconducting bulk bodies may be larger than the inner diameter of the ring-shaped oxide superconducting bulk body adjacent to the central oxide superconducting bulk body.

The height in the layered direction (Z-axis direction) of the ring-shaped oxide superconducting bulk body whose inner diameter is larger than the inner diameter of the adjacent ring-shaped oxide superconducting bulk body may be 10 mm to 30 mm.

In the bulk magnet structure, a columnar oxide superconducting bulk body may be further layered.

A columnar oxide superconducting bulk body may be disposed at one of the ends in the layered direction of the bulk magnet structure.

The thickness of the ring-shaped oxide superconducting bulk body constituting the stack with the second planar ring is preferably 10 mm or less.

In addition, a second outer circumferential reinforcing ring may be provided between the oxide superconducting bulk body and the outer circumferential reinforcing ring.

An inner circumferential reinforcing ring may be provided inside the ring-shaped oxide superconducting bulk body.

A second inner circumferential reinforcing ring may be provided between the ring-shaped oxide superconducting bulk body and the inner circumferential reinforcing ring.

At least any one of the second planar ring, the outer circumferential reinforcing ring, the second outer circumferential reinforcing ring, the inner circumferential reinforcing ring and the second inner circumferential reinforcing ring has a thermal conductivity of 20 W/(m·K) or more, or is made of a material having a tensile strength at room temperature of 80 MPa or more.

The ring-shaped oxide superconducting bulk bodies or the columnar oxide superconducting bulk bodies may be layered such that c-axis directions of the crystal axis of the ring-shaped oxide superconducting bulk bodies or the columnar oxide superconducting bulk bodies substantially coincide with the inner circumferential axis of the ring-shaped oxide superconducting bulk bodies or the columnar oxide superconducting bulk bodies, and a-axis directions of the crystal axis of the ring-shaped oxide superconducting bulk bodies or the columnar oxide superconducting bulk bodies are shifted within a predetermined angular range to each other.

Among the oxide superconducting bulk bodies constituting the bulk magnet structure, at least one ring-shaped oxide superconducting bulk body or columnar oxide superconducting bulk body may have a multiple ring structure whose inner circumferential axes of the rings coincide to each other.

At least one of the ring-shaped oxide superconducting bulk bodies may form a stack in which a ring-shaped oxide superconducting bulk body and a first planar ring are alternately arranged.

The oxide superconducting bulk body may comprise an oxide having a structure in which $RE_2BaCuO_5$ is dispersed in a monocrystalline $REBa_2Cu_3O_y$ (RE is one or two or more elements selected from rare earth elements, $6.8 \leq y \leq 7.1$).

It is to be noted that the specific items concerning the bulk magnet structure described above may be appropriately combined in various aspects of the present invention within a range not causing particularly inconvenience.

In order to solve the above problems, according to still another aspect of the present invention, there is provided a magnet system for NMR comprising any one of the above bulk magnet structures housed in a vacuum vessel, a cooling device for cooling the bulk magnet structure, and a temperature controller for adjusting a temperature of the bulk magnet structure.

In order to solve the above problems, according to one aspect of the present invention, there is provided a magnetization method for a bulk magnet structure, wherein the bulk magnet structure comprises at least one ring-shaped oxide superconducting bulk body and is configured by layering a ring-shaped oxide superconducting bulk body or a columnar oxide superconducting bulk body, the method comprises a basic magnetization step in which, in a state where the superconducting state of the bulk magnet structure is maintained by a temperature controller for adjusting a temperature of the bulk magnet structure and a magnetic field generator for applying a magnetic field to the bulk magnet structure, the strength of the applied magnetic field applied to the bulk magnet structure is decreased by the magnetic field generator, and after the basic magnetization step, the bulk magnet magnetic structure is magnetized by controlling at least one of the temperature controller or the magnetic field generator so that the magnetic field distribution of at least a partial region in the axial direction of the bulk magnet structure forms a magnetic field uniformization region having more uniform magnetic field distribution than the applied magnetic field distribution before magnetization.

The ratio of the difference between the maximum magnetic field strength and the minimum magnetic field strength with respect to the average magnetic field strength obtained from the magnetic field distribution in an arbitrary region having a predetermined interval in the axial direction of the bulk magnet structure represents uniformity of the magnetic field. When it is used as a uniformity evaluation index, the uniformity evaluation index of the applied magnetic field distribution before magnetization in the magnetic field uniformization region may be 100 ppm or more.

The ratio of the difference between the maximum magnetic field strength and the minimum magnetic field strength with respect to the average magnetic field strength obtained from the magnetic field distribution in an arbitrary region having a predetermined interval in the axial direction of the bulk magnet structure represents the uniformity of the magnetic field. When it is used as a uniformity evaluation index, the uniformity evaluation index of the applied magnetic field distribution before magnetization in the magnetic field uniformization region may be 100 ppm or more, and the uniformity evaluation index of the magnetic field distribution of the bulk magnet structure in the corresponding region after magnetization may be smaller than the uniformity evaluation index of the applied magnetic field distribution before magnetization and may be less than 100 ppm. The smaller the uniformity evaluation index is, the higher the uniformity is. Therefore, it is better if the lower limit value is lower. However, in order to set the uniformity evaluation index to 0, extremely high precision design, construction and operation are required. For example, it may be adjusted depending on an actual application and cost-effectiveness required, and for example, may be 2 ppm or more, 4 ppm or more, 6 ppm or more, 10 ppm or more, 15 ppm or more, 20 ppm or more, 25 ppm or more, 30 ppm or more, 35 ppm or more, 40 ppm or more, 45 ppm or more, or 50 ppm or more,.

Further, the magnetization method of the bulk magnet structure may comprise, after the basic magnetization step, a first temperature adjustment step in which the temperature of the bulk magnet structure is maintained or raised to a predetermined temperature to improve the uniformity of the magnetic field distribution in the magnetic field uniformization region, and after the first temperature adjustment step, a second temperature adjustment step in which the temperature of the bulk magnet structure is lowered.

Here, the applied magnetic field distribution in the axial direction of the bulk magnet structure before magnetization by the magnetic field generator is upwardly convex or downwardly convex at the central portion of the magnetic field. In the first temperature adjustment step, the superconducting current distribution of the ring-shaped oxide superconducting bulk body located at the central portion of the bulk magnet structure is changed.

In the first temperature adjustment step, the ring-shaped oxide superconducting bulk body located at the central portion of the bulk magnet structure is brought into a fully magnetized state in which a superconducting current will flow through the entire ring-shaped oxide superconducting bulk body.

In addition, the applied magnetic field distribution in the axial direction of the bulk magnet structure before magnetization by the magnetic field generator is upwardly convex or downwardly convex at the central portion of the magnetic field. In the central portion of the bulk magnet structure, a stack in which a superconducting bulk body and a first planar ring are alternately layered may be positioned.

Here, the thickness of the ring-shaped oxide superconducting bulk body constituting the stack with the first planar ring may be 5 mm or less.

The applied magnetic field distribution in the axial direction of the bulk magnet structure before magnetization by the magnetic field generator is upwardly convex or downwardly convex at the magnetic field central portion or the central adjacent portions sandwiching the magnetic field central portion. At least one of the oxide superconducting bulk bodies constituting the bulk magnetic structure may be formed by a stack of a ring-shaped oxide superconducting bulk body and a second planar ring, and the second planar ring may be made of a metal.

Here, the thickness of the ring-shaped oxide superconducting bulk body constituting the stack with the second planar ring may be 10 mm or less.

The above bulk magnet structure may be a magnet for NMR.

The bulk magnet structure which can be magnetized by the above magnetization method may be the bulk magnet structure as described above.

[EFFECT OF THE INVENTION]

As mentioned above, according to the present invention, a bulk magnet structure capable of being magnetized in a manner having a more uniform magnetic field, even using a nonuniform applied magnetic field, and its magnetization method can be obtained.

BRIEF DESCRIPTION OF DRAWINGS

FIG. 1 is an explanatory diagram showing a schematic configuration of a magnetization system for magnetizing a bulk magnet structure according to an embodiment of the present invention.

FIG. 2 relates to a magnetization method of a bulk magnet structure according to an embodiment of the present invention, and is an explanatory view showing an example of a nonuniform applied magnetic field distribution applied to a bulk magnet structure and an example of the uniformized magnetic field in a bulk magnet structure after magnetization.

FIG. 3A is an explanatory view showing an example of a magnetization method used for magnetizing a bulk magnet structure for a conventional small NMR.

FIG. 3B is an explanatory view showing a magnetization method of a bulk magnet structure according to an embodiment of the present invention.

FIG. 4 is an explanatory view showing an external view and a cross-sectional view of a ring-shaped oxide superconducting bulk body.

FIG.5A is a conceptual diagram of a current distribution and a magnetic field distribution of an oxide superconducting bulk body under magnetization condition 1;

FIG.5B is a conceptual diagram of a current distribution and a magnetic field distribution of an oxide superconducting bulk body under magnetization condition 2;

FIG.5C is a conceptual diagram of a current distribution and a magnetic field distribution of an oxide superconducting bulk body under magnetization condition 3.

FIG. 6 is a schematic cross-sectional view showing one configuration example of a bulk magnet structure according to one embodiment of the present invention.

FIG.7 is an explanatory view showing an example of a magnetic field distribution when the temperature after the basic magnetization step of the bulk magnet structure of FIG. 6 is increased.

FIG. 8 is a schematic cross-sectional view showing another configuration example of the bulk magnet structure according to the same embodiment.

FIG.9 is a schematic cross-sectional view showing another configuration example of the bulk magnet structure according to the same embodiment.

FIG. 10 is a schematic exploded perspective view showing an example of a stack consisting of a ring-shaped bulk body and a first planar ring according to a first embodiment.

FIG. 11A is a schematic exploded perspective view showing an example of a stack consisting of a ring-shaped bulk body and a first planar ring according to a second embodiment.

FIG.11B is a partial cross-sectional view of the bulk magnet shown in FIG. 11A.

FIG. 11C shows a partial cross-sectional view of a modified example of a stack consisting of a ring-shaped bulk body and a first planar ring according to the same embodiment, taken along the center axis of the bulk magnet.

FIG. 11D shows a partial cross-sectional view of another modified example of a stack consisting of a ring-shaped bulk body and a first planar ring according to the same embodiment, taken along the central axis of the bulk magnet.

FIG. 12 is a schematic exploded perspective view showing an example of a stack consisting of a ring-shaped bulk body and a first planar ring according to a third embodiment.

FIG. 13 is a schematic exploded perspective view showing an example of a stack consisting of a ring-shaped bulk body and a first planar ring according to a fourth embodiment.

FIG. 14A is a schematic exploded perspective view showing an example of a stack consisting of a ring-shaped bulk body and a first planar ring according to a fifth embodiment.

FIG.14B shows a partial cross-sectional view of a modified example of a stack consisting of a ring-shaped bulk body and a first planar ring according to the same embodiment, taken along the center axis of the bulk magnet.

FIG. 14C shows a partial cross-sectional view of another modified example of a stack consisting of a ring-shaped bulk body and a first planar ring according to the same embodiment, taken along the central axis of the bulk magnet.

FIG. 14D shows a partial cross-sectional view of another modified example of a stack consisting of a ring-shaped bulk body and a first planar ring according to the same embodiment, taken along the central axis of the bulk magnet.

FIG. 14E shows a partial cross-sectional view of another modified example of a stack consisting of a ring-shaped bulk body and a first planar ring according to the same embodiment, taken along the central axis of the bulk magnet.

FIG. 15A shows a partial cross-sectional view of a stack consisting of a ring-shaped bulk body and a first planar ring according to a sixth embodiment, taken along the central axis of the bulk magnet.

FIG. 15B shows a partial cross-sectional view of another configuration example of a stack consisting of a ring-shaped bulk body and a first planar ring according to the same embodiment, taken along the central axis of the bulk magnet.

FIG. 15C shows a partial cross-sectional view of another configuration example of a stack consisting of a ring-shaped bulk body and a first planar ring according to the same embodiment, taken along the central axis of the bulk magnet.

FIG. 16 is an explanatory view showing a fluctuation of a crystallographic orientation of a ring-shaped bulk body.

FIG. 17A is a schematic exploded perspective view showing an example of a stack consisting of a ring-shaped bulk body and a first planar ring according to an eighth embodiment.

FIG. 17B shows a plan view of a ring-shaped bulk body, which is a configuration example of a stack ring-shaped bulk body consisting of a ring-shaped bulk body and a first planar ring according to the same embodiment.

FIG. 17C shows a plan view of a ring-shaped bulk body, which is another configuration example of a stack ring-shaped bulk body consisting of a ring-shaped bulk body and a first planar ring according to the same embodiment.

FIG. 17D shows a plan view of a ring-shaped bulk body, which is another configuration example of a stack ring-shaped bulk body consisting of a ring-shaped bulk body and a first planar ring according to the same embodiment.

FIG. 18 is an explanatory view showing measurement results of a magnetic field distribution on a central axis of a bulk magnet structure in each step of magnetization in Example 1.

FIG.19 is a schematic cross-sectional view showing a configuration of a bulk magnet structure as a magnetization target in Example 3.

FIG.20A is a schematic cross-sectional view showing a configuration of a bulk magnet structure as a magnetization target in Example 4.

FIG. 20B is a schematic cross-sectional view showing a configuration of two bulk magnets disposed at end portions of a bulk magnet structure in Example 4.

FIG. 21A is a schematic cross-sectional view showing a configuration of a bulk magnet structure as a magnetization target in Example 5.

FIG. 21B is a schematic cross-sectional view showing a configuration of a disk-shaped bulk magnet provided on one end in Example 5.

FIG. 21C is an explanatory view showing a schematic configuration of a magnetization system for magnetizing the bulk magnet structure shown in FIG. 21A.

[EMBODIMENTS FOR CARRYING OUT THE INVENTION]

Preferred embodiments of the present invention will now be described in detail with reference to the accompanying drawings. In the present specification and the drawings, the same reference numerals are given to the constituent elements having substantially the same functional configuration to omit redundant explanations.

First, the oxide superconducting bulk body used in an embodiment of the present invention will be described. The oxide superconducting bulk body used in this embodiment may have a structure in which a non-superconducting phase typified by a $RE_2BaCuO_5$ phase (211 phase) or the like is finely dispersed in a monocrystalline $REBa_2Cu_3O_7 - x$ (so-called QMG (registered trademark) Material). The term "monocrystalline" as used herein means not only a perfect mono-crystal but also those having defects that are practically usable, such as low angle grain boundaries. RE in $REBa_2Cu_3O_{7-x}$ phase (123 phase) and $RE_2BaCu_5$ phase (211 phase) is a rare earth element consisting of Y, La, Nd, Sm, Eu, Gd, Dy, Ho, Er, Tm, Yb, Lu and combinations thereof. The 123 phase including La, Nd, Sm, Eu or Gd is out of the stoichiometric composition of 1: 2: 3, and Ba may partially be substituted in the site of RE in some cases. Also, in the 211 phase which is the non-superconducting phase, La and Nd are somewhat different from Y, Sm, Eu, Gd, Dy, Ho, Er, Tm, Yb and Lu, and it is known that they may lead a non-stoichiometric composition ratio of metal elements or a different crystal structure.

Substitution of Ba element as described above tends to lower the critical temperature. Also, substitution of Ba element tends to be suppressed in an environment with a lower oxygen partial pressure.

The 123 phase is formed by a peritectic reaction of the 211 phase with a liquid phase composed of a composite oxide of Ba and Cu.

$$211 \text{ phase} + \text{liquid phase (composite oxide of Ba and Cu)} \rightarrow 123 \text{ phase}$$

Then, the temperature at which the 123 phase can be formed (Tf: 123 phase generation temperature) by this peritectic reaction generally relates to an ionic radius of the RE element, and Tf decreases as the ion radius decreases. In addition, Tf tends to decrease with a low oxygen atmosphere and Ag addition.

A material in which the 211 phase is finely dispersed in the monocrystalline 123 phase can be formed because unreacted 123 grains are left in the 123 phase when the 123 phase grows crystal. That is, the oxide superconducting bulk body is formed by the following reaction.

$$211 \text{ phase} + \text{liquid phase (composite oxide of Ba and Cu)} \rightarrow 123 \text{ phase} + 211 \text{ phase}$$

The fine dispersion of the 211 phase in the oxide superconducting bulk body is extremely important from the viewpoint of Jc improvement. By adding a trace amount of at least one of Pt, Rh or Ce, grain growth of the 211 phase in the semi-molten state (a state composed of the 211 phase and the liquid phase) is suppressed, and as a result, the 211 phase in the material is miniaturized to about 1 $\mu$m. From the viewpoints of the amount at which the miniaturization effect appears and the material cost, it is desired that the addition amount is 0.2 to 2.0 % by mass for Pt, 0.01 to 0.5 % by mass for Rh, 0.5 to 2.0 % by mass for Ce. A part of the added Pt, Rh or Ce is solid-solved in the 123 phase. In addition, an element which cannot be solid-solved forms a composite oxide with Ba or Cu to be scattered in the material.

Further, the bulk oxide superconducting body constituting the magnet needs to have a high critical current density (Jc) even in a magnetic field. In order to satisfy this requirement, it is necessary to be a monocrystalline 123 phase which does not include a high angle grain boundary which leads to a superconductively weak bond. In order to have even higher Jc characteristics, a pinning center for stopping the movement of the magnetic flux is required. The finely dispersed 211 phase functions as this pinning center, and thus it is preferable that a large number of the 211 phases are finely dispersed. As mentioned earlier, Pt, Rh and Ce have a function to promote miniaturization of the 211 phase. In addition, the possibility of $BaCeO_3$, $BaSiO_3$, $BaGeO_3$, $BaSnO_3$ or the like as a pinning site is known. In addition, a non-superconducting phase such as 211 phase mechanically strengthens the superconducting body by being finely dispersed in the 123 phase which is easy to cleave, and it also plays an important role to make the bulk material usable.

From the viewpoint of Jc characteristics and mechanical strength, the ratio of 211 phase in 123 phase is preferably 5 to 35 % by volume. In addition, the material generally contains 5 to 20% by volume of voids (air bubbles) of about 50 to 500 $\mu$m. When Ag is added, Ag or Ag compound of about 1 to 500 $\mu$m in size is included in an amount from more than 0% by volume to no more than 25% by volume, depending on the added amount.

In addition, when oxygen deficiency amount (x) in the material after crystal growth is about 0.5, a semiconductor-like temperature-dependent change in resistivity are exhibited. By annealing this in each RE system at 350 °C to 600 °C for about 100 hours in an oxygen atmosphere, oxygen will be incorporated into the material, and the oxygen deficiency amount (x) becomes 0.2 or less, and good superconducting properties are exhibited. At this time, a twin crystal structure is formed in the superconducting phase. However, the material including this aspect will be referred to as a monocrystalline state in the specification.

Next, the concept of a magnetization system and a magnetization method of the bulk magnet structure according to this embodiment will be described.

[Magnetization System Configuration]

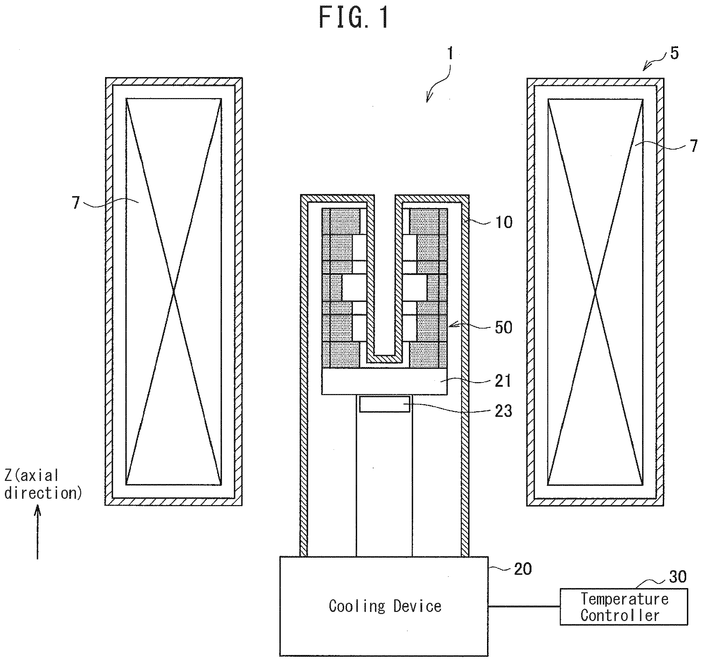

FIG. 1 is an explanatory view showing a schematic configuration of a magnetization system 1 for magnetizing a bulk magnet structure according to this embodiment. As shown in FIG. 1, the magnetization system 1 according to this embodiment includes a magnetic field generator 5, a vacuum heat insulation container 10 in which the bulk magnet structure 100 is housed, a cooling device 20, and a temperature controller 30.

The magnetic field generator 5 is a device for generating an applied magnetic field (external magnetic field) to apply a magnetic field to the bulk magnet structure 50. A tubular superconducting magnet 7 is accommodated in the magnetic field generator 5, and the vacuum heat insulation container 10 can be disposed in the hollow portion. In the vacuum heat insulation container 10, the bulk magnet structure 50 is accommodated.

The bulk magnet structure 50 is disposed in the vacuum heat insulation container 10 in a state of being placed on the cold head 21 of the cooling device 20. As a result, the bulk magnet structure 50 is thermally connected to the cooling device 20 such that the bulk magnet structure 50 can be cooled by the cooling device 20. Further, the cold head 21 is provided with a heater 23 for raising a temperature of the bulk magnet structure 50. Further, one or more of temperature sensors (not shown) for measuring temperatures inside the container may be installed in the vacuum heat insulation container 10. The temperature sensor may be installed, for example, at the upper part of the vacuum insulation container 10 or in the vicinity of the cold head 21 on which the bulk magnet structure 50 is placed.

The cooling device 20 is a device for cooling the bulk magnet structure 50. As the cooling device 20, for example, a refrigerant such as liquid helium or liquid neon, a GM freezer (Gifford-McMahon cooler), a pulse tube freezer or the like can be used. The cooling device 20 is controlled and driven by a temperature controller 30. The temperature controller 30 controls the cooling device 20 so that the temperature of the bulk magnet structure 50 reaches a desired temperature according to each step of magnetization.

[Outline of Magnetization Method]

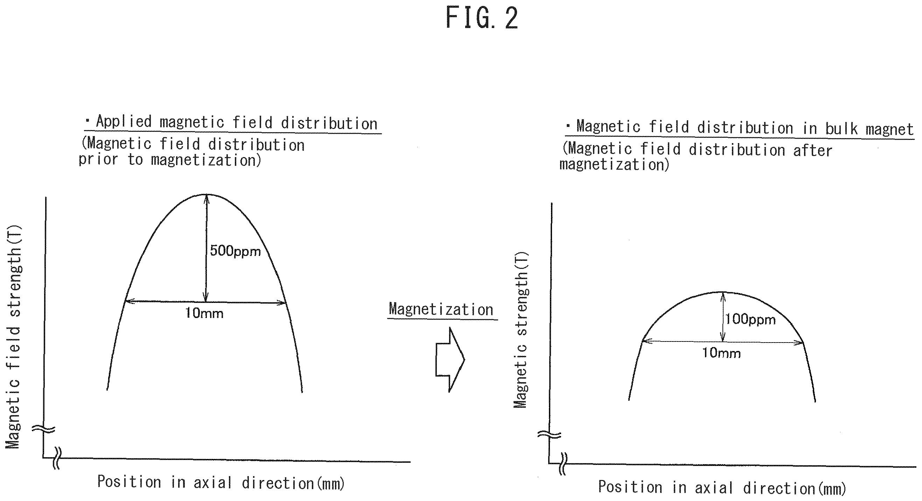

When magnetizing the bulk magnet structure using the magnetization system 1 shown in FIG. 1, for example, for the bulk magnet structure applied to NMR and MRI, a strong magnetic field of several T and high uniformity on the order of ppm are required. However, as shown in the left side of FIG. 2, the distribution of the applied magnetic field applied to the bulk magnet structure which is not a conventional NMR / MRI magnet by a relatively inexpensive and common magnetic field generator 5 is not uniform in the axial direction (Z direction) of the bulk magnet structure. For example, there may be a deviation of about 500 ppm in magnetic field strength within the range of 10 mm in the axial direction from the position of the peak of the magnetic field strength in the center of the range. When the bulk magnet structure is magnetized by the conventional magnetization method with such an applied magnetic field, the magnetic field distribution of the bulk magnet structure also has a similar distribution and a nonuniform magnetic field is copied to the bulk magnet structure.

Here, as a uniformity evaluation index of the magnetic field distribution, a ratio of the difference between the maximum magnetic field strength and the minimum magnetic field strength with respect to the average magnetic field strength in a certain region is expressed in ppm. In MRI magnets, high magnetic field uniformity as high as about ppm order is often required as a uniformity evaluation index of the applied magnetic field distribution in a region where it is desired to make the magnetic field distribution uniformized (that is, the magnetic field uniformization region). On the other hand, the uniformity of the magnetic field which can be generated by a magnetic field generator which is not mainly intended to generate a highly uniform magnetic field such as by NMR or MRI is relatively low, and the magnetic field uniformity required in the magnetic field uniformization region is often 100 ppm or more as indicated by the uniformity evaluation index of the applied magnetic field distribution. Therefore, it is useful and preferred that the magnetization method of the present invention is applied by using a relatively inexpensive magnetic field generator such that the uniformity evaluation index of the applied magnetic field distribution before magnetization in the magnetic field uniformization region is 100 ppm or more. Further, it is more preferable by using such a relatively inexpensive magnetic field generator to achieve the uniformity evaluation index of the magnetic field distribution of the bulk magnet structure after magnetization to less than 100 ppm, and further preferably to 50 ppm or less. However, even in the case of magnetizing with an applied magnetic field distribution having a high uniformity of 100 ppm or less, the present magnetization method can achieve an even higher uniformity, and therefore there is no doubt that it can achieve high effectiveness.

Incidentally, the magnetic field strength at a certain point can be roughly evaluated based on Hall element or a highly-sensitive magnetic field measuring device (for example, Teslameter (manufactured by Metrolab)), the half value width of NMR signal, and the like. In addition, the maximum magnetic field strength and the minimum magnetic field strength are the highest magnetic field strength value and the lowest magnetic field strength value in a certain region, and the average magnetic field strength is the average value of the maximum magnetic field strength and the minimum magnetic field strength.

In the magnetization method of the bulk magnet structure according to the present invention, the bulk magnet structure is intended to be magnetized by using a nonuniform static magnetic field without changing the distribution of the applied magnetic field generated by the external magnetic field generator 5 such that the bulk magnet structure can obtain a more uniform magnetic field. For example, as shown on the right side of FIG. 2, by making the peak of the magnetic field distribution in the bulk magnet structure magnetized by the applied magnetic field smaller than the peak of the applied magnetic field (for example, set to about 1/5 or less), the magnetic field distribution of the bulk magnet structure within a predetermined range in the axial direction becomes uniform.

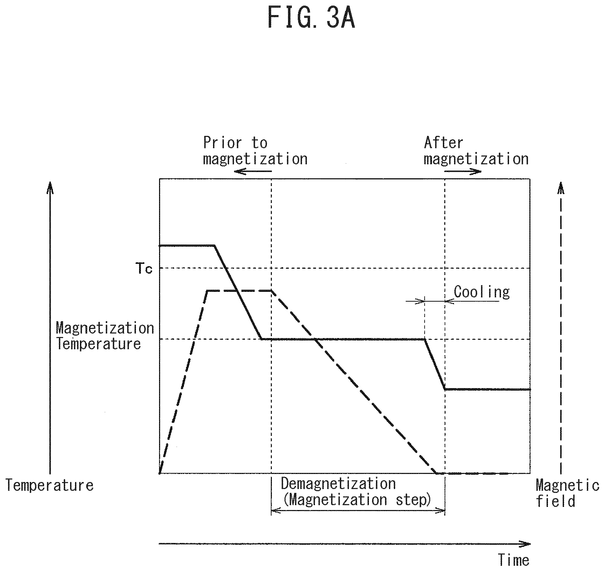

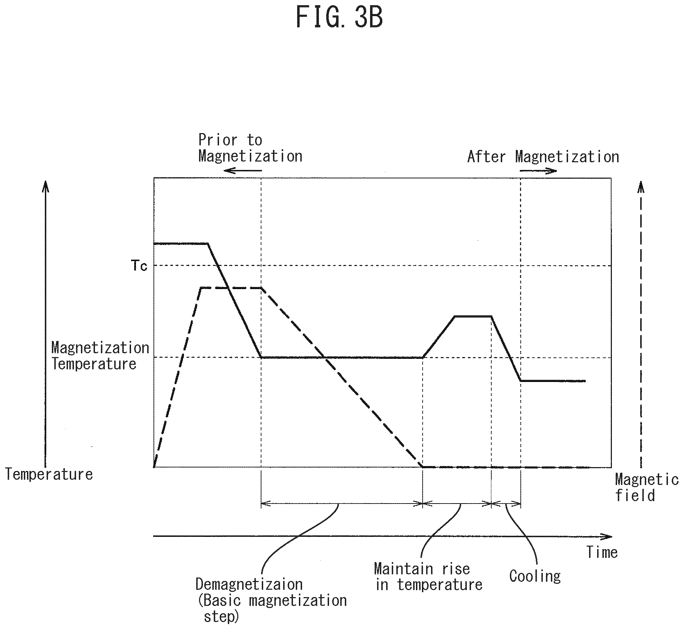

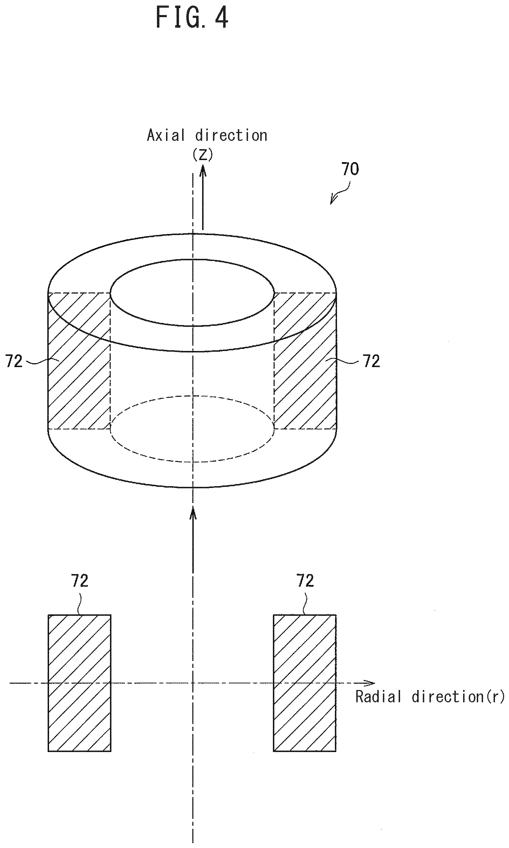

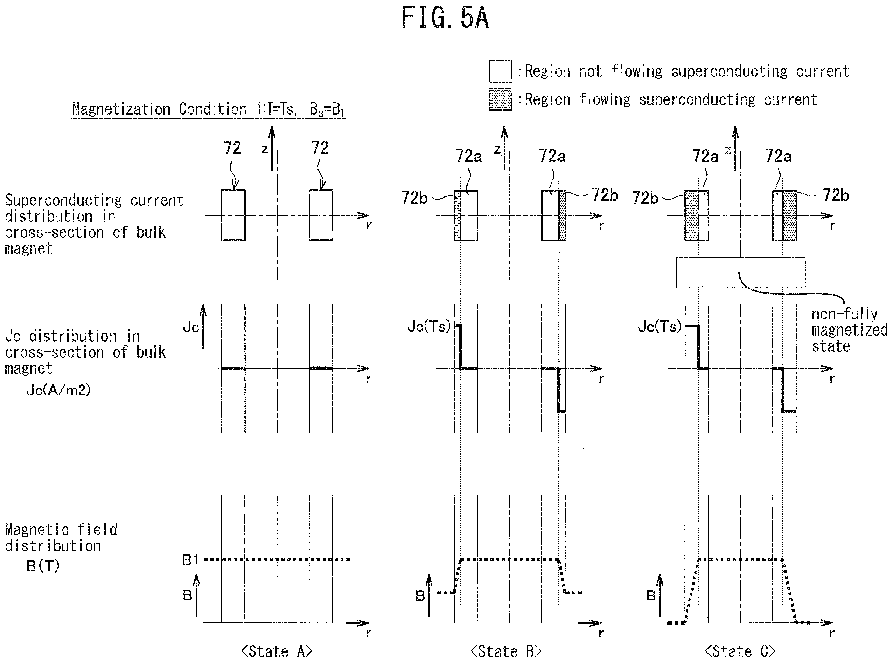

The magnetization method of the bulk magnet structure according to this embodiment will be described in more detail below with reference to FIGS. 3A to 5C. Here, FIG. 3A is an explanatory view showing an example of a magnetization method used for magnetizing a bulk magnet structure for a conventional small NMR. FIG. 3B is an explanatory view showing a magnetization method of a bulk magnet structure according to an embodiment of the present invention. FIG. 4 is an explanatory view showing an external view and a cross-sectional view of a ring-shaped oxide superconducting bulk body. FIGS. 5A to 5C are conceptual diagrams of the current distribution and the magnetic field distribution of the oxide superconducting bulk body magnetized under magnetization conditions 1 to 3. Incidentally, in the following description, the ring-shaped oxide superconducting bulk body is also referred to as "ring-shaped bulk body."

First, a conventional magnetization method of a bulk magnet structure and a magnetization method of a bulk magnet structure according to an embodiment of the present invention will be compared to each other and described with reference to FIGS. 3A and 3B. In FIGS. 3A and 3B, the solid line shows a temperature of a bulk magnet structure controlled by the temperature controller, and the broken line shows the magnetic field strength of the applied magnetic field generated by the magnetic field generator.

As shown in FIG. 3A, in the conventional magnetization method of a bulk magnet structure, first, as a pre-magnetization step, an applied magnetic field to be applied to a bulk magnet structure is generated by the magnetic field generator and the magnetic field strength is increased until a predetermined magnetic field strength is obtained. Then, when the predetermined applied magnetic field is formed, the temperature controller starts cooling the bulk magnet structure to a predetermined temperature (magnetization temperature) equal to or lower than the superconducting transition temperature (Tc). Once it is cooled to the magnetization temperature, the magnetic field generator gradually reduces the applied magnetic field and performs magnetization processing of the bulk magnet structure. A state before demagnetization by the magnetic field generator (that is, magnetization processing of the bulk magnet structure) is started is referred to as a pre-magnetized state.

In order to suppress the flux creep in which the magnetic flux captured in the bulk magnet structure decreases, before the end of the magnetization process that demagnetizes the applied magnetic field and increases the region where the superconducting current flows in the bulk magnet structure, the temperature is lowered from the magnetization temperature to a predetermined temperature by the temperature controller to stabilize the magnetic field distribution copied to the bulk magnet structure. A state after the temperature is lowered to a predetermined temperature for suppressing flux creep is referred to as a post magnetized state.

In the magnetization method shown in FIG. 3A, when an applied magnetic field as shown on the left side of FIG. 2 is applied to the bulk magnet structure, a similar magnetic field distribution is copied to the bulk magnet structure, resulting in a nonuniform magnetic field distribution. Therefore, in the magnetization method according to this embodiment, as shown in FIG. 3B, after the demagnetization, a step of once elevating the temperature of the bulk magnet structure or holding a predetermined temperature higher than the target magnetization temperature is performed. Thereafter, by performing a cooling step for suppressing flux creep, the magnetic field distribution in at least a part of the axial range of the bulk magnet structure is made uniform.

Here, the magnetized state in the magnetization method according to this embodiment will be described with reference to FIG. 4 and FIGS. 5A to 5C. Here, the magnetized states of the ring-shaped oxide superconducting bulk body 70 as shown in FIG. 4, for example, are considered under some magnetization conditions. FIGS.5A to 5C are diagrams showing magnetized states in the bulk magnet structure in the basic magnetization step: under the respective magnetization conditions, the magnetic field applied to the bulk magnet structure in the normal conduction state is brought to a superconductive state, thereafter, the bulk magnet structure is cooled, and then the applied magnetic field is removed. In FIG. 5A to 5C, a region 72a where the superconducting current does not flow and a region 72b where the superconducting current flows are shown, using the cross-sectional view 72 of the superconducting bulk body 70 along the axial direction and the radial direction shown in FIG. 4, along with the critical current density distribution and the magnetic field distribution in the cross-section.

(Magnetization condition 1: $T = T_S$, $B_a = B_1$)

First, as the magnetization condition 1, a ring-shaped oxide superconducting bulk body in a normal conduction state was placed in a magnetic field $B_1$, cooled it to a temperature Ts not higher than the superconducting transition temperature (Tc), and then the applied magnetic field was gradually decreased. The superconducting current distribution and magnetic field distribution in the oxide superconducting bulk body at this time are shown in FIG. 5A. The state A is in a state before demagnetization, and no superconducting current flows in the oxide superconducting bulk body. As the applied magnetic field is gradually reduced, as shown in the state B, a region 72b in which the superconducting current having the value of the critical current density Jc (Ts) flows appears from the outer circumferential portion in the ring-shaped oxide superconducting bulk body. After a further reduction of the applied magnetic field, if the applied magnetic field is reduced to zero, the region 72 b in which the superconducting current having the critical current density Jc (Ts) flows further expands inward as shown in the state C, as shown in the state C. In the magnetization condition 1, as shown in the state C, even when the applied magnetic field becomes zero, there is a region 72a in which no superconducting current flows in the cross section of the oxide superconducting bulk body. Such a state is hereinafter referred to as "non-fully magnetized state".

(Magnetization condition 2: $T = T_h$ ($T_h > T_S$), $B_a = B_1$)

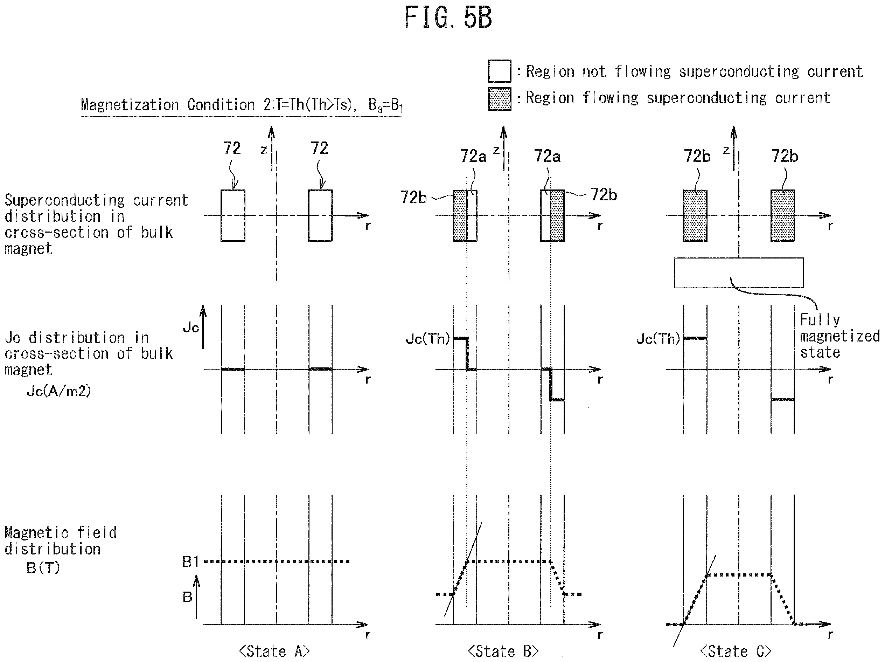

Next, in the magnetization condition 2, the applied magnetic field is the same as the magnetization condition 1, but the oxide superconducting bulk body was brought to temperature $T_h$ higher than the temperature $T_S$ under the magnetization condition 1. In the magnetization condition 2 where the temperature is higher than that in the magnetization condition 1 and the critical current density Jc is low, as shown in FIG. 5B, in the state A before demagnetization, like the magnetization condition 1, no superconducting current flows in the oxide superconducting bulk body. As the applied magnetic field is gradually reduced, as shown in the state B, a region 72b in which the superconducting current having the value of the critical current density Jc (Ts) flows appears from the outer circumferential portion in the ring-shaped oxide superconducting bulk body. At this time, a region 72b in which the superconducting current flows expands to the inner portion at an earlier stage than in the magnetization condition 1. Then, in the state C where, after a further reduction of the applied magnetic field, the applied magnetic field is reduced to zero, a superconducting current flows through the entire cross section of the oxide superconducting bulk body. Such a state is hereinafter referred to as "fully magnetized state".

(Magnetization condition 3: $T = T_S$, $B_a = B_2$ $(B_2 > B_1)$)

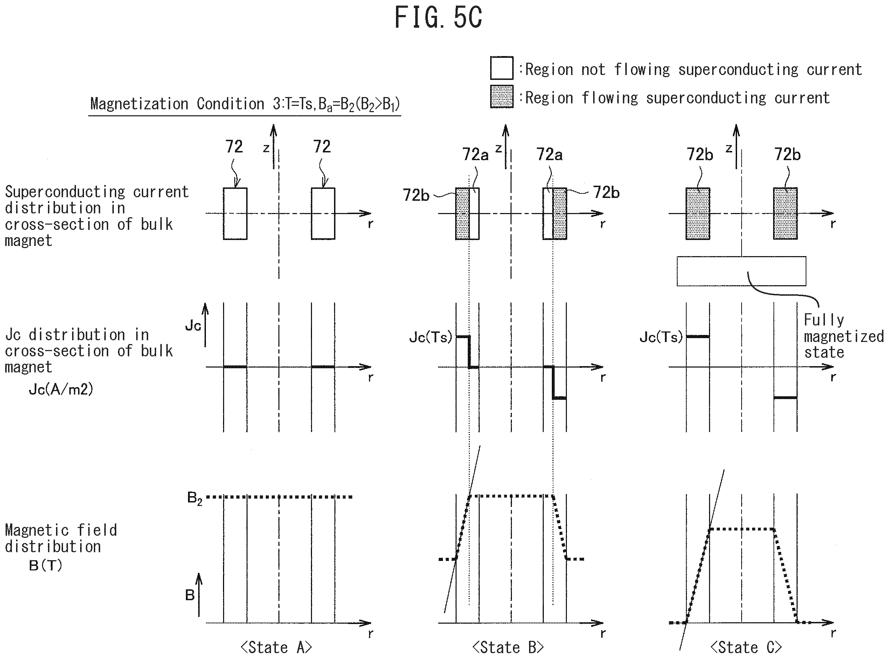

On the other hand, in the magnetization condition 3, the magnetization temperature was the same as in the magnetization condition 1, but the applied magnetic field was made higher than in the magnetization condition 1. Under such magnetization conditions, superconducting current does not flow in the oxide superconducting bulk body as in the magnetization conditions 1 and 2 in the state A before demagnetization, as shown in FIG. 5C. As the applied magnetic field is gradually reduced, as shown in the state B, a region 72b in which the superconducting current having the value of the critical current density Jc (Ts) flows appears from the outer circumferential portion in the ring-shaped oxide superconducting bulk body. At this time, like in the magnetization condition 2, a region 72b in which the superconducting current flows expands to the inner portion at an earlier stage than in the magnetization condition 1. Then, in the state C where, after a further reduction of the applied magnetic field, the applied magnetic field is reduced to zero, a superconducting current flows through the entire cross-section of the oxide superconducting bulk body, and is in the fully magnetized state.

Further, when paying attention to the gradient of the magnetic flux density in the cross-section of the oxide superconducting bulk body, it can be seen from FIG. 5B and FIG. 5C that the gradient of the magnetic flux density is proportional to the critical current density Jc. In FIGS. 5A to 5C, three magnetization conditions are shown assuming that the critical current density Jc is constant (that is, does not change), with respect to a temperature. However, in fact, it decreases logarithmically with time. Therefore, the magnetic flux captured in the ring-shaped oxide superconducting bulk body decreases with time. This phenomenon that gradually decreases with time is called creep. However, in the case of the non-fully magnetized state as in the magnetization condition 1, even if the critical current density Jc decreases due to creep, the superconducting current will start to flow in the region where the superconducting current has not yet flowed to compensate the flow reduction of the critical current density Jc. Therefore, the magnetic flux inside the oxide superconducting bulk body decreases only slightly as the current distribution changes. On the other hand, in the case of the magnetization conditions 2 and 3, all the reduction in the critical current density Jc due to creep leads to a change in the magnetic flux density in the oxide superconducting bulk body, and the creep of the magnetic field significantly appears.

Furthermore, in FIGS. 5A to 5C, a conceptual view of a ring-shaped oxide superconducting bulk body that is sufficiently long in the axial direction is shown, but since the actual length is finite, a bulk magnet located at the end in the axial direction does not have an adjacent bulk magnet on one side. Therefore, since the magnetic field rapidly decreases and the magnetic field gradient increases, a large critical current flows, and accordingly, a region where the critical current flows expands to the inner circumference side. As a result, the critical current density Jc distribution in the cross-section of the oxide superconducting bulk body penetrates more inwardly at the upper and lower end portions, and the magnetic field strength captured at the upper and lower end portions decreases.

In consideration of the above findings, according to the magnetization method of the bulk magnet structure according to this embodiment, when the oxide superconducting bulk body is magnetized by using a nonuniform applied magnetic field distribution, the bulk magnetic structure is magnetized by controlling at least one of the temperature controller and the magnetic field generator so that the magnetic field distribution of at least a part of the region in the axial direction of the bulk magnet structure becomes a magnetic field uniformization region which is more uniform than the applied magnetic field distribution before magnetization. As described above, the magnetization is that the superconducting bulk body is magnetized by the superconducting current induced by changing the applied magnetic field in the superconducting state, and is the step of making the superconducting bulk body function as a magnet. Here, this magnetization step is called a basic magnetization step.

For example, as shown on the left side of FIG. 2, the nonuniform applied magnetic field distribution for magnetizing the oxide superconducting bulk body has a peak of an applied magnetic field distribution at the center in the axial direction. Within the range of 10 mm from the peak position in the center, there is a difference in magnetic field strength of about 500 ppm. Incidentally, the applied magnetic field distribution is a distribution on the symmetry axis (Z axis) of the winding coil wound in a substantially concentric tubular shape. Generally, the applied magnetic field is generated by a superconducting magnet (for general purpose experiment etc.) other than the superconducting magnet for NMR which requires a high uniformity of the magnetic field.

On the other hand, in the application to the conventional small NMR, the bulk magnet structure has been magnetized in the applied magnetic field having ppm order uniformity by the superconducting magnet for NMR. Therefore, a highly uniform applied magnetic field (uniformity of magnetic field on the order of ppm) is copied into the bulk magnet structure. However, according to the this embodiment, by controlling at least one of the temperature controller and the magnetic field generator in the nonuniform applied magnetic field distribution, the magnetic field distribution of at least a part of the region in the axial direction of the bulk magnet structure can be made more uniform than the applied magnetic field distribution before magnetization. For example, as shown on the right side of FIG. 2, the peak of the magnetic field strength at the center portion in the axial direction becomes small, and thus it is possible to greatly improve the magnetic field uniformity. Thus, it is an essence of the present invention to provide a bulk magnet structure and a magnetization method of the bulk magnet structure, which make it possible to greatly improve the magnetic field distribution in the bulk magnet structure after magnetization as compared to the nonuniform applied magnetic field distribution before magnetization.

In general, the magnetic field strength, the spatial uniformity of the magnetic field and the volume of the uniform magnetic field space are important indices for magnets (such as magnets for experimental, NMR, MRI purpose, etc.) for generating a desired magnetic field space. Magnets for NMR and MRI are required to have a high magnetic field uniformity as compared to general magnets for experimental use. Also, in general, the MRI magnet requires a larger uniform magnetic field space as compared to the NMR magnet, since the object to be measured is larger. However, the uniformity may be about one digit lower due to the difference in measurement method. In general, general-purpose laboratory magnets are inexpensive as a high uniformity is not required.

All of these magnets are designed to obtain a high magnetic field, high uniformity, large space magnetic field as much as possible. Magnets that are designed with this idea generally have a structure in which the coils are concentrically wound so as to maximize symmetry (axial symmetry, symmetry of axis to two directions) as much as possible. In such a structure, the magnetic field distribution represented by $y = f(x)$, wherein x direction is the axial direction and y direction is the radial direction, basically has an extreme value of zero for the differential value ($dy/dx$) at the central position of the magnet. That is, a magnet having a finite volume has a magnetic field distribution that is either upwardly convex or downwardly convex. When the magnetic field distribution is upwardly convex, the magnetic field strength will have a peak, and when the magnetic field distribution is downwardly convex, the magnetic field strength will have a minimum value.

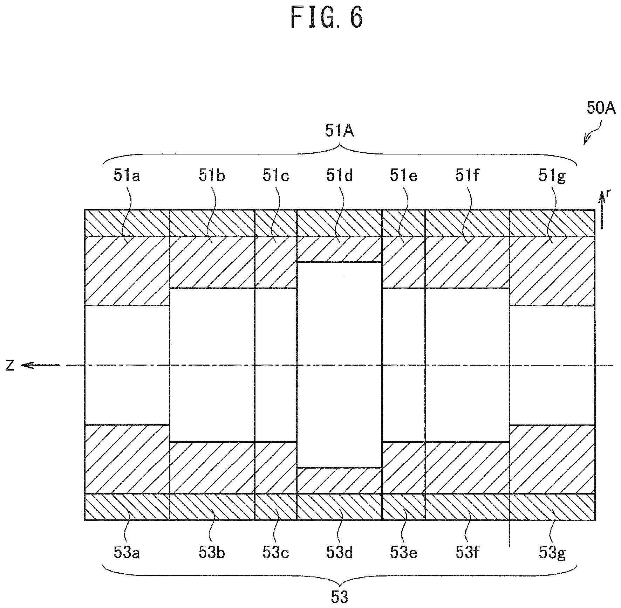

Here, in the present invention, it is necessary to change the nonuniform applied magnetic field distribution before magnetization which is to be transferred to the bulk magnet structure to a uniform magnetic field distribution. Therefore, in the present invention, as shown in FIGS. 6, 8 and 9, for example, the bulk magnet structure is configured such that the inner diameter of the ring-shaped bulk body corresponding to the region where the magnetic field distribution is desired to be uniform (magnetic field uniformization region) is made larger than the inner diameter of the other ring-shaped bulk bodies. The ring-shaped bulk body corresponding to the region where the magnetic field distribution is desired to be uniform (magnetic field uniformization region) may be located in the central portion in the layered direction of the bulk magnet structure. Incidentally, in this specification, the central portion in the layered direction of the ring-shaped oxide superconducting bulk bodies may be read as a portion corresponding to the measuring portion of the ring-shaped oxide superconducting bulk bodies.

(Configuration A)

For example, the bulk magnet structure 50A shown in FIG. 6 comprises a ring-shaped bulk body portion 51A composed of a plurality of ring-shaped bulk bodies 51a to 51g, and an outer circumferential reinforcing ring portion 53 composed of a plurality of outer circumferential reinforcing rings 53a to 53g fitted to the outer circumferential portion of each of the ring-shaped bulk bodies 51a to 51g. The bulk magnet structure 50A is formed by layering the ring-shaped bulk bodies 51 a to 51 g so that the central axes of the bulk bodies are aligned. They are layered such that each of the ring-shaped bulk bodies 51a to 51g has the same outer diameter, but its inner diameter becomes larger (that is, the thickness in the radial direction becomes smaller) toward the center in the axial direction. Specifically, the inner diameter of the ring-shaped bulk bodies 51a and 51g located at both ends in the axial direction is the minimum, and the inner diameter of the central ring-shaped bulk body 51d is the maximum. In FIG. 6, the inner diameters of the ring-shaped bulk bodies 51b, 51c, 51e and 51f are set smaller than the maximum inner diameter and larger than the minimum inner diameter. In the magnetization method according to one embodiment of the present invention, a large electromagnetic force can act on the ring-shaped bulk body. For example, a stress causing destruction is exerted on the ring-shaped bulk body such as a pulling force (hoop force) in the circumferential direction which is to inflate the ring-shaped bulk body. Therefore, the bulk magnet structure according to one embodiment of the present invention comprises includes an outer circumferential reinforcing ring. By providing the outer circumferential reinforcing ring, breakage of the ring-shaped bulk body can be prevented even when a large electromagnetic force (stress) is exerted on the ring-shaped bulk body.

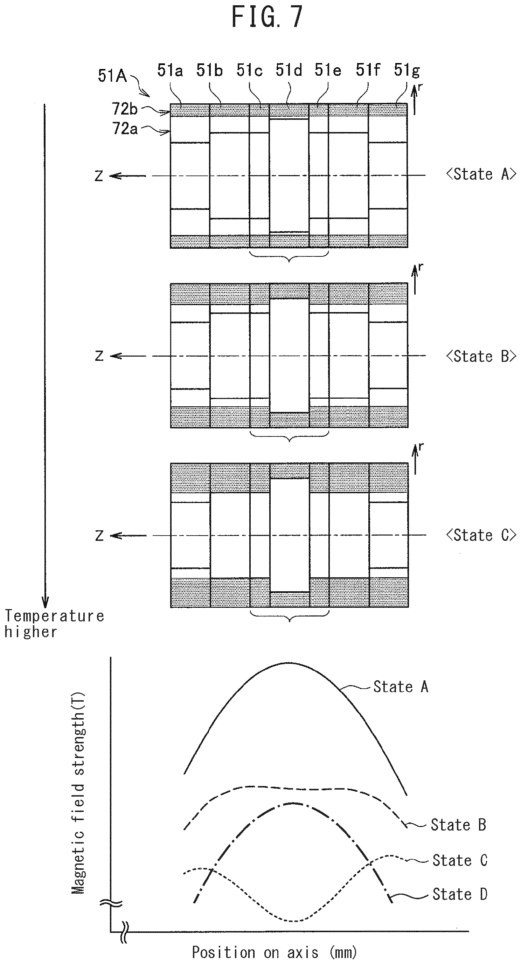

In such a bulk magnet structure 50A shown in FIG. 6, magnetization is performed in a step as shown in FIG. 3B so as to make the magnetic field distribution uniform in the vicinity of the central ring-shaped bulk member 51d having the largest inner diameter. That is, the bulk magnet structure 50A including the ring-shaped bulk body portion 51A composed of a plurality of ring-shaped bulk bodies 51a-51g as shown in FIG. 6 is placed on the cold head in the vacuum heat insulation container, and firstly, it is magnetized at a temperature sufficiently low to achieve a non-fully magnetized state in which the magnetic field distribution of the bulk magnet structure as a whole hardly changes. Next, the temperature of the bulk magnet structure is gradually increased, to make only the central ring-shaped bulk body 51d having a small thickness at least in the radial direction brought into the fully magnetized state, and thereafter cooling for suppressing the flux creep is performed. This makes it possible to lower the magnetic flux density which is too high in the ring-shaped bulk body at the axially central portion in the fully magnetized state to make the magnetic flux density uniform. Here, if the inner diameter of 51d shown in FIG. 6 is the same as 51b, 51c, 51e and 51f (that is, the height in the axial direction from 51b to 51f is 80 mm), the state D in Fig.7 is obtained, and the uniformization of the magnetic field does not occur. The thickness (height) in the Z axial direction of 51d in which uniformization successfully occurs as in the state B depends on the shape of the applied magnetic field distribution. The thickness (height) in the Z-axial direction of each ring-shaped bulk body such as 51d may be 10 mm to 30 mm. Within this range, it is possible to easily obtain a uniform magnetic field according to the present invention.

The axial length of the sample tube used for NMR spectroscopy is generally about 20 mm, and the uniformity of the magnetic field in this region is important. When the thickness of each ring-shaped bulk body such as 51d in the Z-axial direction is 10 mm to 30 mm, it is possible to more effectively uniformize the magnetic field distribution. As an example, it is desirable that the difference between the inner diameter of 51d in FIG. 6 and the inner diameters of 51c and 51e which is on both sides of 51d be 1 mm or more from the viewpoint of dimensional accuracy.

In the patent (Japanese Patent No. 6090557) corresponding to Patent Document 5, "A superconducting body having a tubular shape provided with an inner space portion having the same axial core as an axial core of the columnar outer shape,

wherein the inner space portion includes a central space portion located at a center in a direction along the axial core and end space portions located on both sides of the central space portion in a direction along the axis core,

wherein an inner dimension of the central space portion in a direction perpendicular to the axial core is larger than an inner dimension of the end space portions in a direction perpendicular to the axial core,

wherein the inner space portion has a first corner portion at which a first surface and a second surface which intersect perpendicularly to said axial core of the central space portion intersect a lateral surface along the direction of the axial core of the two end space portions, and a second corner portion at which the first surface and the second surface intersect a lateral surface along the direction of the axial core of the central space portion,

wherein the second corner portion is located in a region where no superconducting current flows and located in a region more inner side than a region where the superconducting current flows. " is disclosed. In this superconducting body, the entire superconducting body is in a non-fully magnetized state and does not have a ring-shaped bulk body in a fully magnetized state.

The second corner portion of Patent Document 5 corresponds to the inner circumferential corner portion of 51d in FIG. 6 according to the present invention. However, the inner circumferential corner portion of 51d is in the fully magnetized state, that is, in the region where the superconducting current flows. In other words, according to one embodiment of the present invention, "a superconducting body wherein the second corner portion is located at a boundary (outer side) of a region where a superconducting current flows inside the superconducting body, and is located at a region (boundary) where a superconducting current flows." is obtained.

For example, FIG. 7 shows an example of the magnetic field distribution when the temperature of the bulk magnet structure 50A of FIG. 6 is raised after the basic magnetization step. In FIG. 7, the temperature is raised to a higher temperature in order of state A, state B, and state C. In the state A of FIG. 7, the region 72a in which no superconducting current flows is present in all the ring-shaped bulk bodies 51 a to 51 g, but when the temperature is further raised, as shown in the state B, first, the ring-shaped bulk body 51d having the smallest thickness in the radial direction entirely becomes a region 72b through which the superconducting current flows, and the fully magnetized state is obtained. When the temperature is further raised, as shown in the state C, the ring-shaped bulk bodies 51b, 51c, 51e and 51f having a smaller thickness in the radial direction than the ring-shaped bulk body 51d are brought into the fully magnetized state.

Looking at the distribution of the magnetic field strength in the central region (here assumed to be the axial region of the ring-shaped bulk bodies 51c to 51e), in the states A to C in FIG. 7 as shown in the lower side of FIG. 7, the magnetic field strength peaks of the state A, state B and state C are lowered in this order, and as a result, the magnetic field distribution is made uniform in this region. In this manner, by increasing the temperature from the magnetization temperature to a predetermined temperature after the basic magnetization step, the magnetic field strength distribution in a predetermined region in the axial direction can be made uniform. Incidentally, in the state D of FIG. 7,

14

as described above, the inner diameter of 51d shown in FIG. 6 is the same as that of 51b, 51c, 51e and 51f, and the height in the axial direction from 51b to 51f is 80 mm. In this case, the magnetic field is not made uniform.

(Configuration B)

In the configuration A shown in FIG. 6, in order to lower the magnetic flux density which is too high in the central portion in the axial direction of the bulk magnet structure 50A, a ring-shaped bulk body with a smaller thickness in the radial direction is arranged in that region. As another constitution, for example, by forming the ring-shaped bulk body in the axially central portion such that a ring-shaped bulk body having a small thickness in the axial direction and a first planar ring are alternately layered, it is possible to reduce the magnetic flux in the central portion. In other words, the first planar ring may be adopted for a ring-shaped bulk body at the axially central portion in the layering direction of the bulk magnet structure.

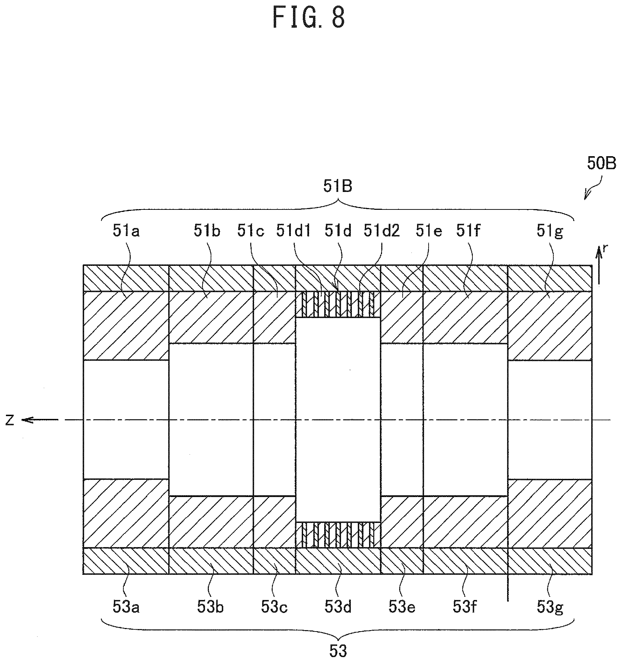

Specifically, as shown in FIG. 8, the bulk magnet structure 50B includes a ring-shaped bulk body portion 51B consisting of a plurality of ring-shaped bulk bodies 51a-51c, 51e-51 g, and a stack 51d consisting of a ring-shaped bulk body and a first planar ring(hereinafter also simply referred to as "stack"), and an outer circumferential reinforcing ring portion 53 consisting of a plurality of outer circumferential reinforcing rings 53a-53g fitted to the outer circumferential surface of each of the ring-shaped bulk bodies 51a-51c, 51e-51 g and the stack 51d. The bulk magnet structure 50B is formed by layering the respective ring-shaped bulk bodies 51a-51c, 51e-51g and the stack 51d such that their central axes are aligned to each other. Although each of the ring-shaped bulk bodies 51a-51c, 51e-51g and the stack 51d has the same outer diameter, they are layered such that their inner diameter becomes larger (that is, their thickness in the radial direction becomes smaller) toward the center in the axial direction. Specifically, the inner diameters of the ring-shaped bulk bodies 51a and 51g located at both ends in the axial direction are the minimum, and the inner diameter of the stack 51d at the center is the maximum. In FIG. 8, the inner diameters of the ring-shaped bulk bodies 51b, 51c, 51e and 51f are set smaller than the maximum inner diameter and larger than the minimum inner diameter.

The stack 51d is configured by alternately layering a ring-shaped bulk body 51d1 having a small thickness in the axial direction and a first planar ring 51d2. In this case, the ring-shaped bulk bodies 51d1 are positioned at both axial ends of the stack 51d. A superconducting current flows in the cross-section of the ring-shaped bulk body 51d1 to maintain the magnetic flux density in the central portion of the stack 51d. However, as the first planar ring 51d2 is present, the current amount that can maintain the magnetic field in the central portion becomes lower. For this reason, when the temperature is raised, the fully magnetized state is reached at an earlier stage than the ring-shaped bulk body adjacent to the stack 51d. Therefore, by gradually raising the temperature, it becomes possible to lower the magnetic flux density which is too high in the central portion and to make the magnetic flux density uniform.

In other words, by providing the stack 51d in which the relatively thin ring-shaped bulk body 51d1 and the first planar ring 51d2 are alternately layered on at least a part of the axial direction of the bulk magnet structure 50B, the average critical current of the bulk magnet structure 50B substantially having the above layered structure is lowered and a fully magnetized state can be achieved at an earlier stage than the surrounding bulk magnets. Incidentally, when the critical current of stack 51d comprising the thin ring-shaped bulk body and the first planar ring layered to each other is controlled in order to form a region with excellent uniformity in the axially central portion of the bulk magnet structure 50B, it is preferred that both of the thicknesses of the ring-shaped bulk body and the first planar ring are thinner, from the viewpoint of the uniformity of the current distribution. The thickness of the first planar ring is relatively easier to adjust than the ring bulk body. Regarding the ring-shaped bulk body, it depends on the diameter (outer diameter) from the viewpoints of processing yield and workability. The thickness of the ring-shaped bulk member 51d1 is desirably 5 mm or less, more desirably 2 mm or less, and 0.3 mm or more. When the thickness of the ring-shaped bulk body 51d1 is 0.3 mm or less, the ring-shaped bulk body 51d1 tends to easily crack and ununiform characteristics of the ring-shaped bulk body are likely to occur. The first planar ring adjusts the ratio of the ring-shaped bulk body to the first planar ring in the bulk magnet including the first planar ring, and adjusts the cross-sectional area of the superconducting body of the bulk magnet. Therefore, its thickness is desirably 5 mm or less, more desirably 2 mm or less, corresponding to the thickness of the ring-shaped bulk body. In addition, the first planar ring may be made of a non-superconducting material, and the same configuration as the second planar ring described later may be adopted for the first planar ring.

(Configuration C)

When applied to NMR and MRI that require a uniform strong magnetic field, a large electromagnetic force would act on the ring-shaped bulk body. For example, a stress causing destruction such as a pulling force (hoop force) in the circumferential direction which is to inflate the ring-shaped bulk body is exerted on the ring-shaped bulk body. Therefore, reinforcement with the conventional outer circumferential reinforcing ring may be insufficient in some cases. For this reason, the ring-shaped bulk bodies at both ends in the axial direction, on which the greatest stress acts in the bulk magnet structure, may be formed by alternately layering a ring-shaped bulk body having a small axial thickness and a second planar ring to reinforce them. In other words, the second planar ring may be adopted for a ring-shaped bulk body at the axially end portions in the layering direction of the bulk magnet structure.

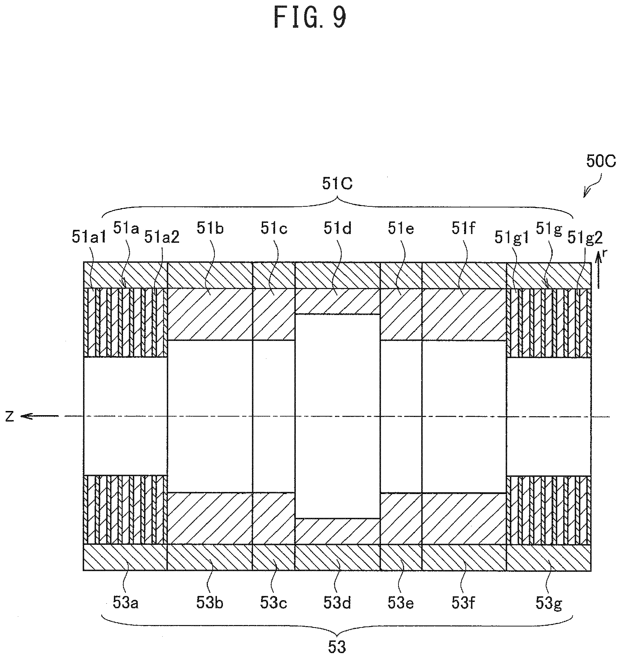

For example, as shown in FIG. 9, the bulk magnet structure 50C includes a ring-shaped bulk body portion 51C consisting of a plurality of ring-shaped bulk bodies 51b-51f and stacks 51a and 51g, and an outer circumferential reinforcing ring portion 53 consisting of a plurality of outer circumferential reinforcing rings 53a- 53g fitted to the outer circumferential surface of the ring-shaped bulk bodies 51b to 51f and stacks 51a-51g, respectively. The bulk magnet structure 50C is formed by layering the ring-shaped bulk bodies 51b-51f, and the stacks 51a and 51g such that their central axes are aligned to each other. Although each of the ring-shaped bulk bodies 51b-51f and the stacks 51a and 51g has the same outer diameter, they are layered such that their inner diameter becomes larger (that is, their thickness in the radial direction becomes smaller) toward the center in the axial direction. Specifically, the inner diameters of the stacks 51a and 51g located at both ends in the axial direction are the minimum, and the inner diameter of the ring-shaped bulk body 51d at the center is the maximum. In FIG. 9, the inner diameters of the ring-shaped bulk bodies 51b, 51c, 51e and 51f are set smaller than the maximum inner diameter and larger than the minimum inner diameter.

The stacks 51a and 51g are configured by alternately layering a ring-shaped bulk body 51a1, 51g1 having a small thickness in the axial direction and a second planar ring 51a2, 51a2. In this case, the ring-shaped bulk bodies 51a1, 51g1 are positioned at both axial ends of the stacks 51a, 51g. This is because the both axial ends of the bulk magnet structure 50C where the stack 51a and 51g are disposed are the portions on which the greatest stress acts. Among these, especially in the vicinity of the inner surface portions and both axial end surfaces, large stress acts. Therefore, it is preferable that at least the bulk magnet disposed at the end of the bulk magnet structure has sufficient mechanical strength. Therefore, it is preferable that ring-shaped bulk bodies 51a1 and 51g1 are positioned at both axial ends of the stacks 51a and 51g. Further, in order to obtain a higher mechanical strength, a stack in which a ring-shaped bulk body having a small thickness in the axial direction and a second planar ring are alternately layered to each other may be used for the ring-shaped bulk bodies other than ones at both ends in the axial direction.

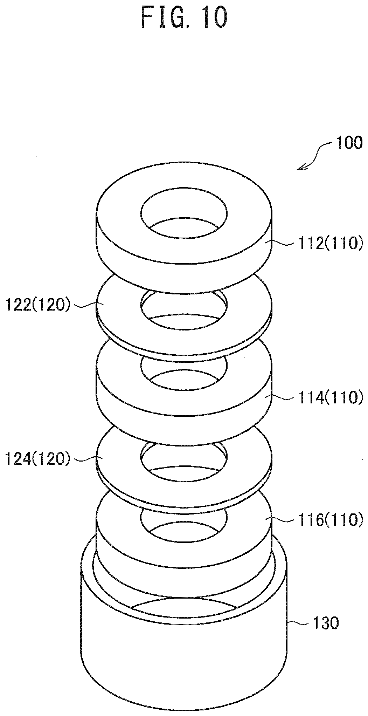

Hereinafter, specific examples of the configuration of the stacks 51a and 51g constituting the bulk magnet structure 50C shown in FIG. 9 and stacks formed by alternatingly layering a ring-shaped bulk body having a small thickness in the axial direction and a second planar ring for any of the ring-shaped bulk bodies 51b to 51f will be described with reference to FIGS. 10 to 17D.

(First Embodiment)

Firstly, a first embodiment of the stack will be described with reference to FIG. 10. FIG. 10 is a schematic exploded perspective view showing an example of the stack according to the first embodiment.

The bulk magnet 100 according to this embodiment comprises a ring-shaped bulk body 110 having a through-hole at the center of a circular plate, a second planar ring 120 having a through-hole at the center of a circular plate, and an outer circumferential reinforcing ring 130. In this embodiment, three ring-shaped bulk bodies 112, 114 and 116 are provided as the ring-shaped bulk body 110, and two second planar rings 122 and 124 are provided as the second planar ring 120. The ring-shaped bulk body 110 and the second planar ring 120 are alternately layered in the central axial direction of the ring of the bulk magnet. For example, the second planar ring 122 is disposed between the superconducting bulk bodies 112 and 114, and the second planar ring 124 is disposed between the ring-shaped bulk bodies 114 and 116. The layered ring-shaped bulk body 110 and the second planar ring 120 are bonded or adhered, and to their outer circumferential surface, the outer circumferential reinforcing ring 130 made of a hollowed metal is fitted. Thus, a bulk magnet having a central through-hole is formed.

Bonding or adhesion between the ring-shaped bulk body 110 and the second planar ring 120 layered to each other in the central axial direction may be performed by, for example, resin or grease, more preferably by soldering for obtaining stronger bonding force. In the case of soldering, it is desirable to form an Ag thin film on the surface of the ring-shaped bulk body 110 by sputtering or the like, followed by annealing at 100 °C to 500 °C. As a result, the Ag thin film and the surface of the ring-shaped bulk body are well matched. Since the solder itself has a function of improving thermal conductivity, soldering treatment is also desirable from the viewpoint of improving thermal conductivity and equalizing the temperature of the bulk magnet as a whole.

At this time, as a method of reinforcing against electromagnetic stress, the second planar ring 120 is preferably a metal such as a solderable aluminum alloy, Ni-based alloy, nichrome or stainless steel. Furthermore, nichrome is further desirable, since it has a linear expansion coefficient relatively close to that of the ring-shaped bulk body 110 and causes slight compression stress to act on the ring-shaped bulk body 110 upon cooling from room temperature. On the other hand, from the viewpoint of prevention of breakage by quenching, it is preferable to use a metal such as copper, copper alloy, aluminum, aluminum alloy, silver, silver alloy or the like having high thermal conductivity and high electric conductivity as the second planar ring 120. Incidentally, these metals are solderable. Further, oxygen-free copper, aluminum and silver are preferable from the viewpoint of thermal conductivity and electric conductivity. In addition, it is effective to use the second planar ring 120 having pores in order to restrain bubble entrainment and so on and permeate the solder uniformly when being bonded with solder or the like.

By the reinforcement by the second planar ring 120 made of such a metal, due to the thermal conductivity as a whole, thermal stability as a bulk magnet is increased and quenching is less likely to occur, and high field magnetization in a lower temperature region, that is, in the high critical current density Jc region becomes possible. Since metals such as copper, aluminum and silver have high electrical conductivity, it is expected that, when a cradle causing local degradation of superconducting properties occurs, it can be expected to detour the superconducting current and have a quench suppressing effect. In this case, in order to enhance the quench suppressing effect, it is desirable that the contact resistance at the interface between the ring-shaped bulk body and the high electrically conductive second planar ring be small, and it is desirable to bond them with solder, etc., after forming a silver film on the surface of the ring-shaped bulk body.

In the practical design of the bulk magnet, since the proportion of the superconducting material decreases by the insertion of the second planar ring 120 made of a metal, the proportion of the second planar ring 120 may be determined according to the intended use condition. From the above viewpoint, it is preferable that the second planar ring 120 is formed by combining a plurality of metals selected from metal having a high strength and metals having a high thermal conductivity and determining their ratio.

Further, a normal temperature tensile strength of the ring-shaped bulk body 110 is about 60 MPa, and a normal temperature tensile strength of the solder for attaching the second planar ring 120 to the ring-shaped bulk body 110 is usually less than 80 MPa. Accordingly, the second planar ring 120 having a normal temperature tensile strength of 80 MPa or more is effective as a reinforcing member. Therefore, the second planar ring 120 preferably has a normal temperature tensile strength of 80 MPa or more. Further, from the viewpoint of transfer and absorption of heat generated in the superconducting material, the thermal conductivity of the metal having a high thermal conductivity is preferably 20W/(m·K) or more, and more preferably 100W/(m·K) or more in the temperature range of 20 K to 70 K. In the case where a plurality of types of second planar rings are disposed between the ring-shaped bulk bodies 110 as the second planar ring 120, at least one of the second planar rings has a thermal conductivity of 20W/(m·K) or more.

Also, the outer circumferential reinforcing ring 130 may be made of a material having a high thermal conductivity in order to enhance the quench suppressing effect. In this case, for example, a material containing a metal such as copper, aluminum, silver or the like having a high thermal conductivity as a main component can be used for the outer circumferential reinforcing ring 130. From the viewpoint of transfer and absorption of heat generated in the superconducting material, the thermal conductivity of the circumferential reinforcing ring 130 having a high thermal conductivity is preferably 20W/(m·K) or more, and more preferably 100W/(m·K) or more in the temperature range of 20 K to 70 K by which a strong magnetic field can be stably generated by a freezer cooling or the like.

In addition, the outer circumferential reinforcing ring 130 may be formed by concentrically arranging a plurality of rings. That is, one circumferential reinforcing ring is constituted as a whole in such a manner that the circumferential surfaces of the opposing rings are brought into contact with each other. In this case, it is sufficient that at least one of the rings constituting the outer circumferential reinforcing ring has a thermal conductivity of 20 W/ (m- K) or more.

The processing of the second planar ring 120 and the outer circumferential reinforcing ring 130 is performed by a general machining method. The central axes of the inner and outer circumferences of each ring-shaped bulk body 110 are necessary for improving the strength of generated magnetic field and for improving uniformity (or symmetry) of the magnetic field. In addition, the diameter of the outer circumference and the diameter of the inner circumference of each ring-shaped bulk body 110 are design matters, and do not necessarily have to be matched. For example, in the case of a bulk magnet for NMR or MRI, it may be necessary to arrange a shim coil or the like for enhancing magnetic field uniformity in the vicinity of the center. In doing so, it is desirable to make the inner diameter greater near the center, which makes it easier to place the shim coil or the like. Regarding the diameter of the outer circumference, it is effective to change the diameter of the outer circumferential portion to adjust the target magnetic field strength and its uniformity in order to increase the strength of the magnetic field at the center portion and to improve the uniformity of the magnetic field.

The shape (outer circumference and inner circumference) of the outer circumferential reinforcing ring 130 may be one such that the outer circumferential surface of the ring-shaped bulk body 110 is in close contact with the inner circumferential surface of the outer circumferential reinforcing ring 130. Although FIG. 10 shows an example of a bulk magnet comprising three ring-shaped bulk bodies, the gist of the present invention is that a ring-shaped bulk body having a relatively low strength and a second planar ring having a relatively high strength are combined to make the resulting composite material have a high strength. Therefore, when the number of layers is increased, the composite effect is exhibited. The thickness of the ring-shaped bulk body is desirably 10 mm or less, more desirably 6 mm or less, and 1 mm or more, although it also depends on the diameter (outer diameter). The thickness of the bulk magnet disposed at the end portion in the bulk magnet structure is about 30 mm or less, and when the thickness of the ring-shaped bulk body is 1 mm or less, deterioration of superconductivity occurs due to fluctuation in crystallinity of the oxide superconducting body. In addition, the thickness of the bulk magnet disposed at the end portion in the bulk magnet structure is about 30 mm or less, the number of the ring-shaped bulk body to be used is desirably 3 or more, and more desirably five or more. The second planar ring adjusts the ratio of the second planar ring to the ring-shaped bulk body in the bulk magnet including the second planar ring, and adjusts the strength of the bulk magnet. For this reason, the thickness may be adjusted according to the required strength, and is desirably 2 mm or less, and more desirably 1 mm or less.

The first stack according to this embodiment has been described above. According to this embodiment, the second planar ring 120 is disposed at least between the layered ring-shaped bulk bodies 110. In particular, by alternately layering the ring-shaped bulk body 110 having a relatively low strength against the tensile stress and the second planar ring 120 to obtain a composite material, it is possible to increase the strength of the material. Furthermore, by using a material having a high thermal conductivity for the second planar ring 120 and the outer circumferential reinforcing ring 130, occurrence of quenching can also be suppressed. As a result, breakage of the ring-shaped bulk body 110 can be prevented even under a high magnetic field strength condition, and a sufficient total magnetic flux amount can be obtained inside the bulk magnet, and a bulk magnet structure having an excellent magnetic field uniformity can be provided.

(Second Embodiment)

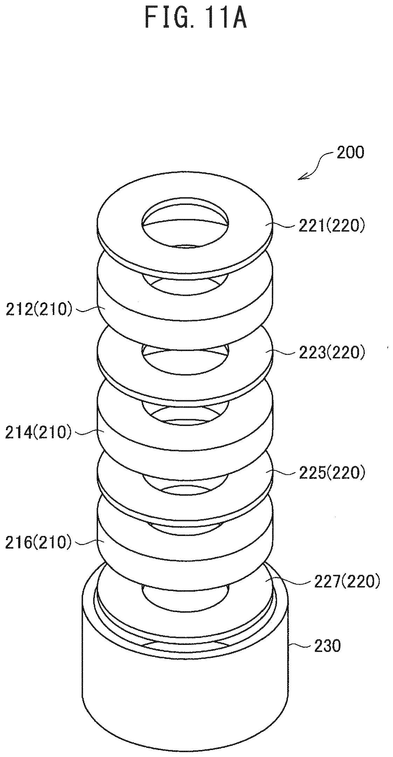

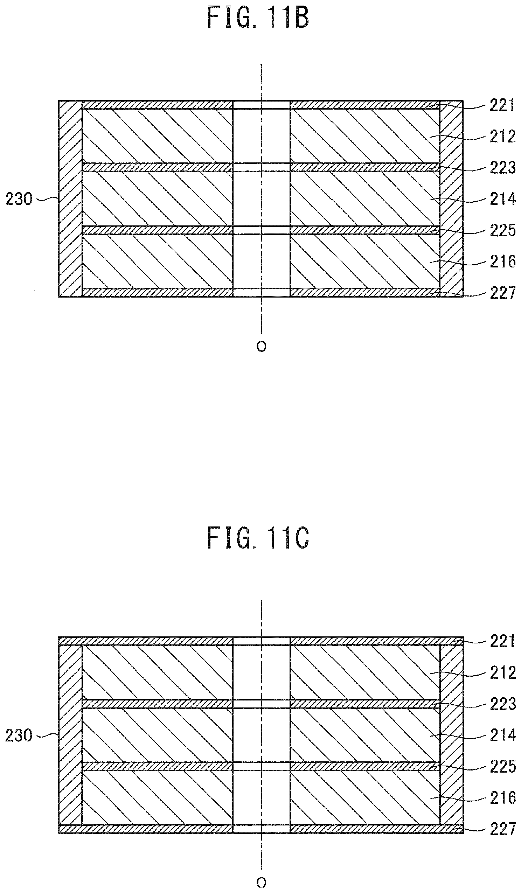

Next, the second embodiment will be described, with reference to FIGS. 11A to 11C. FIG. 11A is a schematic exploded perspective view showing an example of the stack according to the second embodiment. FIG.11B is a partial cross-sectional view of the bulk magnet 200 shown in FIG. 11A. FIG. 11C shows a partial cross-sectional view of a modified example of the second stack, taken along the center axis of the bulk magnet 200.

The second stack 200 differs from the first stack in that the second planar ring 220 is provided at the end in the central axial direction. As shown in FIG. 11A, the bulk magnet 200 comprises a ring-shaped bulk body 210, a second planar ring 220 and an outer circumferential reinforcing ring 230. In this embodiment, three ring-shaped bulk bodies 212, 214 and 216 are provided as the ring-shaped bulk body 210, and four second planar rings 221, 223, 225 and 227 are provided as the second planar ring 220. The ring-shaped bulk body 210 and the second planar ring 220 are alternately layered in the central axial direction of the rings. For example, as shown in FIG. 11A, the second planar ring 223 is disposed between the ring-shaped bulk bodies 212 and 214, and the second planar ring 225 is disposed between the ring-shaped bulk bodies 214 and 216.

Further, the ring-shaped bulk body 212 is provided with a second planar ring 221 on a surface opposite to the side on which the second planar ring 223 is disposed. Similarly, the ring-shaped bulk body 216 is provided with a second planar ring 227 on a surface opposite to the side on which the second planar ring 225 is disposed. In this case, as shown in FIG. 11B, the positional relationship of the second planar ring 221 at the very end portion and the second planar ring 227 at the other very end portion with the outer circumferential ring 230 is such that the second planar rings 221 and 227 may be accommodated in the outer circumferential reinforcing ring 230. Alternatively, as shown in FIG. 11C, the outer diameters of the second planar rings 221 and 227 are substantially equal to the outer diameter of the outer circumferential reinforcing ring 230 so that the edge faces of the outer circumferential reinforcing ring 230 are covered with the second planar rings 221 and 227.

The layered ring-shaped bulk body 210 and the second planar ring 220 are bonded or adhered, and to their outer circumferential surface, an outer circumferential reinforcing ring 230 made of a hollowed metal is fitted. Thus, a bulk magnet having a central through-hole is formed. Incidentally, bonding or adhesion between the ring-shaped bulk body 110 and the second planar ring 120 layered to each other in the central axial direction may be carried out in the same manner as in the case of the first stack.

In FIGS. 11A to 11C, an example wherein the second planar rings 221 and 227 are provided at both ends in the central axial direction of the bulk magnet 200 was shown, but the second planar rings 221 and 227 are not necessarily disposed at both ends. For example, by disposing a bulk magnet in which the reinforcing member 227 is disposed only on the lowermost surface of FIG. 11A under the bulk magnet in which the second planar ring 221 is disposed only on the uppermost surface in FIG. 11A, it is possible to constitute, as a whole, a bulk magnet having the second planar rings 221 and 227 on both of the uppermost and lowermost surfaces.

The second embodiment of the stack has been described above. According to this embodiment, the second planar ring 220 is disposed between the layered ring-shaped bulk bodies 210 and at the ends in the central axial direction. By alternately layering such a ring-shaped bulk body 210 and the second planar ring 220 to form a composite material, its strength can be enhanced. Furthermore, by using a material having a high thermal conductivity as the second planar ring 220 and the outer circumferential reinforcing ring 230, occurrence of quenching can also be suppressed. As a result, breakage of the ring-shaped bulk body 210 can be prevented even under a high magnetic field strength condition, a sufficient total magnetic flux amount can be obtained inside the bulk magnet, and a bulk magnet structure 200 having an excellent magnetic field uniformity can be provided.

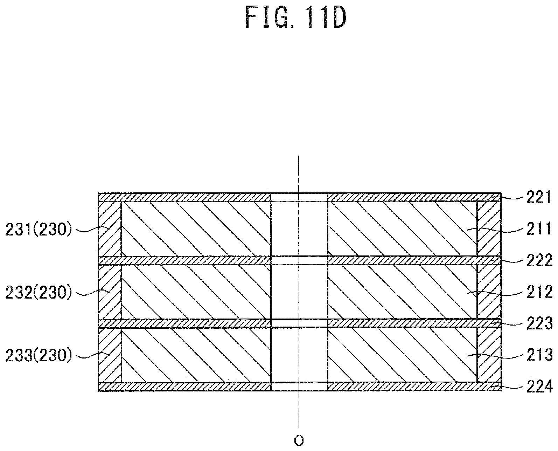

Incidentally, in FIGS. 11A to 11C, one outer circumferential reinforcing ring 230 is provided, but the present invention is not limited to this example. For example, as shown in FIG. 11D, three divided outer circumferential reinforcing rings 321, 232 and 233 corresponding to three ring-shaped bulk bodies 212, 214 and 216 may be provided. In this case, the second planar rings 221, 223, 225 and 227 are extended in the radial direction beyond the ring-shaped bulk bodies 212, 214 and 216 so that their outer diameters are aligned with the outer circumferential reinforcing rings 321, 232 and 233.

(Third Embodiment)

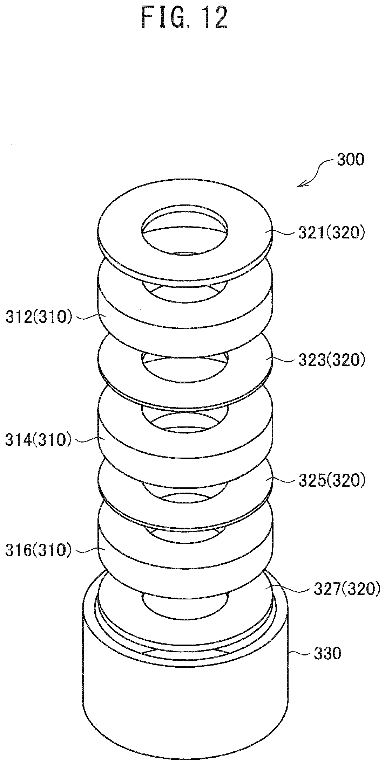

Next, the stack according to the third embodiment will be described with reference to FIG. 12. FIG. 12 is a schematic exploded perspective view showing an example of the stack according to the third embodiment.

As shown in FIG. 12, the bulk magnet 300, which is the stack according to the third embodiment, comprises a ring-shaped bulk body 310, a second planar ring 320 and an outer circumferential reinforcing ring 330. In this embodiment, three ring-shaped bulk bodies 312, 314 and 316 are provided as the ring-shaped bulk body 310, and four second planar rings 321, 323, 325 and 327 are provided as the second planar ring 320.

The ring-shaped bulk body 310 and the second planar ring 320 are alternately layered in the central axial direction of the ring. For example, as shown in FIG. 12, the second planar ring 323 is disposed between the ring-shaped bulk bodies 312 and 314, and the second planar ring 325 is disposed between the ring-shaped bulk bodies 314 and 316. Further, the ring-shaped bulk body 312 is provided with a second planar ring 321 on the surface opposite to the side on which the second planar ring 323 is disposed. Similarly, a ring-shaped bulk body 316 is provided with a second planar ring 327 on a surface opposite to the side on which the second planar ring 325 is disposed. Incidentally, the bonding or adhesion between the ring-shaped bulk body 310 and the second planar ring 320 layered to each other in the central axial direction may be performed in the same manner as the stack according to the first embodiment.

The bulk magnet 300 according to this embodiment is different from the stack according to the second embodiment in that the thickness of at least one of the second planar rings 321 and 327 on the uppermost or lowermost surface in FIG. 12 is thicker than the thickness of the other second planar rings 323 and 325. This is because the maximum stress is applied to the surfaces of the upper surface and the lower surface of the bulk magnet 300 during the magnetization process, and thus it is necessary to sufficiently reinforce this portion. Like the bulk magnet 300 according to this embodiment, by increasing the thickness of reinforcing members 321 and 327 on the uppermost or lowermost surfaces of the bulk magnet 300, it is possible to ensure sufficient strength to withstand the maximum stress.

As in the case of the stack according to the second embodiment, for example, by arranging a bulk magnet in which the second planar ring 321 is disposed only on the uppermost surface in FIG. 12 and a bulk magnet in which the reinforcing member 327 is disposed only on the lowermost surface in FIG. 12 to the bulk magnet structure, it is possible to constitute a bulk magnet structure in which the second planar rings 321 and 327 are disposed on both the uppermost and lowermost surfaces of the bulk magnet structure as a whole.

(Fourth Embodiment)

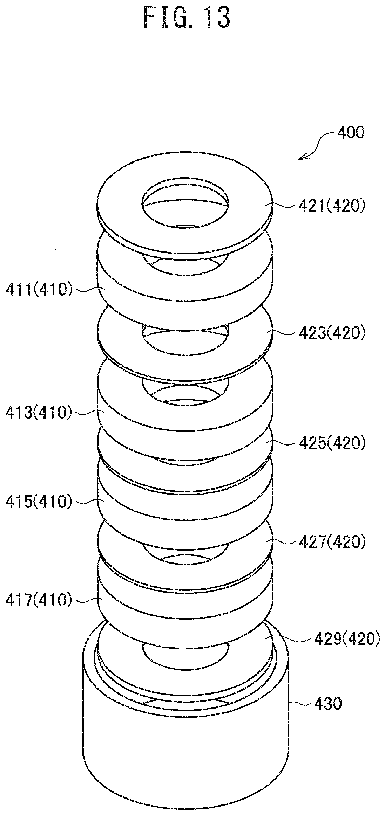

Next, the stack according to the fourth embodiment will be described with reference to FIG. 13. FIG. 13 is a schematic exploded perspective view showing an example of the stack according to the fourth embodiment.

The bulk magnet 400, which is a stack according to the fourth embodiment, comprises a ring-shaped bulk body 410, a second planar ring 420 and an outer circumferential reinforcing ring 430. In the fourth stack, four ring-shaped bulk bodies 412, 414, 416 and 418 are provided as the ring-shaped bulk body 410, and five second planar rings 421, 423, 425, 427 and 429 are provided as the second planar ring 420.

Compared with the first to third stacks, the inner diameter of the second planar ring 420 of the bulk magnet 400 which is the fourth stack is smaller than the inner diameter of the ring-shaped bulk body 410. The inner circumferential surface of the ring-shaped bulk body 410 is a portion where the stress concentrates in the magnetization process. When cracking occurs in the bulk magnet 400, it often occurs from this portion. By reducing the inner diameter of the second planar ring 420, the effect of suppressing the occurrence of cracks from the inner circumferential surface of the ring-shaped bulk body 410 can be enhanced. In addition, when the inner diameters of the ring-shaped bulk bodies 410 disposed above and under the second planar ring 420 are different, the inner diameter of the second planar ring 420 needs to be smaller than the inner diameter of the ring-shaped bulk body having a smaller inner diameter. By strengthening the portion which may become a starting point of the crack, the reinforcing effect against the crack can be enhanced. The starting point of the crack of the ring-shaped bulk body 410 may be on the inner circumferential surface, and it is particularly desirable to reinforce the intersection line portion between the upper surface or the lower surface and the inner circumferential surface. Therefore, by making the inner diameter of the second planar ring 420 smaller than the inner diameter of the ring-shaped bulk body 410 having a smaller inner diameter, it is possible to reinforce the ring-shaped bulk body 410 having a small inner diameter. Furthermore, by using a material having a high thermal conductivity as the second planar ring 420 and the outer circumferential reinforcing ring 430, occurrence of quenching can be suppressed.

(Fifth Embodiment)

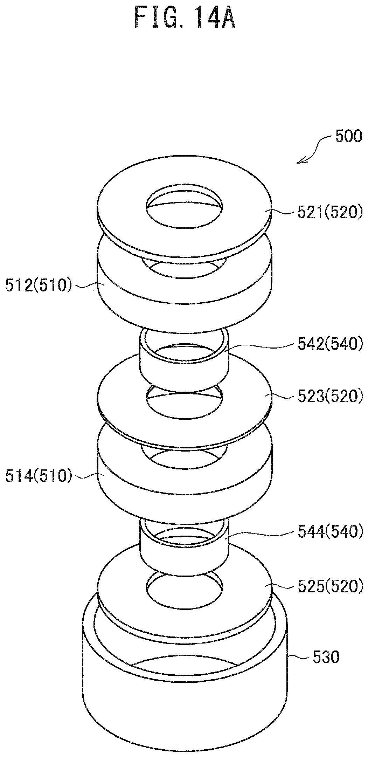

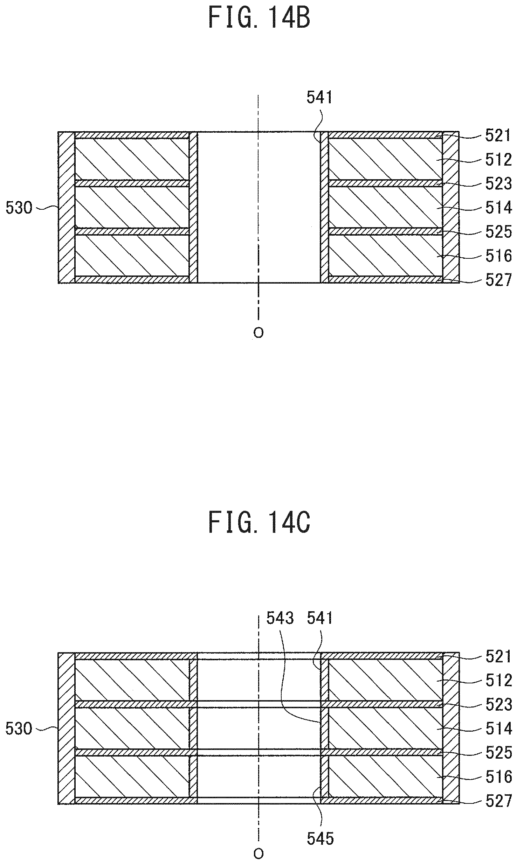

Next, the stack according to the fifth embodiment will be described with reference to FIGS. 14A to 14E. FIG. 14A is a schematic exploded perspective view showing an example of the stack according to the fifth embodiment. FIGS. 14B to 14E shows partial cross-sectional views of modified examples of the stack according to the fifth embodiment, taken along the central axis of the bulk magnet 500.

The bulk magnet 500, which is the fifth stack, comprises a ring-shaped bulk body 510, a second planar ring 520, an outer circumferential reinforcing ring 530 and an inner circumferential reinforcing ring 540. In the example shown in FIG. 14A, two ring-shaped bulk bodies 512 and 514 are provided as the ring-shaped bulk body 510, and three second planar rings 521, 523 and 525 are provided as the second planar ring 520. Further, two inner circumferential reinforcing rings 542 and 544 are provided as the inner circumferential reinforcing ring 540.

Compared to the first to fourth stacks, the bulk magnet 500 which is the fifth stack is different in that an inner circumferential reinforcing ring 540 for reinforcing the inner circumferential surface of the ring-shaped bulk body 510 is bonded or adhered to the inner circumferential surface of the ring-shaped bulk body 510. Since the inner circumferential reinforcing ring 540 is also bonded or adhered to the second planar ring 520, even when its linear expansion coefficient is larger than that of the ring-shaped bulk body 510, the inner circumferential reinforcing ring 540 can be firmly bonded to the inner circumferential surfaces of the ring-shaped bulk body 510 and the second planar ring 520. Therefore, these inner circumferential surfaces can be reinforced, which gives an effect of suppressing cracking.

Furthermore, by using a material having a high thermal conductivity as the second planar ring 520, the inner circumferential reinforcing ring 540 and the outer circumferential reinforcing ring 530, occurrence of quenching can be suppressed. In this case, the second planar ring 520 and the outer circumferential reinforcing ring 530 can be configured similarly to the first stack as described above. Also for the inner circumferential reinforcing ring 540, for example, a material containing a metal having a high thermal conductivity, such as copper, aluminum, silver or the like as a main component can be used in order to enhance the quench suppressing effect. From the viewpoint of transfer and absorption of heat generated in the superconducting material, the thermal conductivity of the inner circumferential reinforcing ring 540 having a high thermal conductivity is desirably 20W/(m·K) or more, and more desirably 100 W/(m·K) or more at a temperature range of 20K to 70K at which temperature a strong magnetic field can be stably generated by a freezer or the like. In addition, the inner circumferential reinforcing ring 540 may be formed by disposing a plurality of rings concentrically. That is, one inner circumferential reinforcing ring can be constituted as a whole by bringing the opposed rings in contact with each other on their circumferential surfaces. In this case, it is sufficient that at least one of the rings constituting the inner circumferential reinforcing ring has a thermal conductivity of 20 W/(m·K) or more.

In this case, it is desirable that the inner circumferential surface of the ring-shaped bulk body 510 and the outer circumferential surface of the inner circumferential reinforcing ring 540 are brought into close contact with each other. Further, as a basic positional relationship between the inner circumferential reinforcing ring 540 and the second planar ring 520, for example, as shown in FIG. 14B, the inner diameter of the ring-shaped bulk body 510 and the inner diameter of the second planar ring 520 are set to be the same so that one inner circumferential reinforcing ring 541 may be provided.

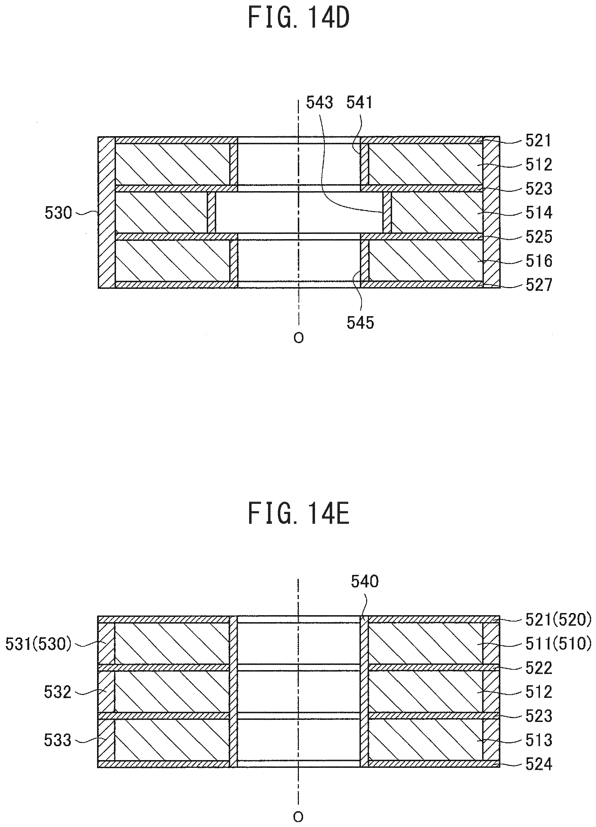

Alternatively, as shown in FIG. 14C, the inner diameter of the second planar ring 520 is slightly smaller than the inner diameter of the ring-shaped bulk body 510, and the inner circumferential surface of each of the ring-shaped bulk bodies 512, 514 and 516 may be provided with inner circumferential reinforcing rings 541, 543 and 545, respectively so that the inner diameters of the second planar rings 521, 523 and 525 and the inner diameters of the inner circumferential reinforcing rings 541, 543 and 545 are the same. In the case where the thickness of the inner circumferential reinforcing ring 540 is larger than the thickness of the second planar ring 520, it is preferable to constitute the structure shown in FIG.14C from the viewpoint of strength. As a result, the contact area between the inner circumferential reinforcing ring 540 and the second planar ring 520 can be increased, and the strength of the connecting portion between the inner circumferential reinforcing ring 540 and the second planar ring 520 can be enhanced. Further, when the inner diameter of the ring-shaped bulk body 510 varies, the inner circumferential reinforcing ring 540 is desirably divided into the inner circumferential reinforcing rings 541, 543 and 545, as shown in FIG. 14D from the viewpoint of workability.

Incidentally, in FIGS.14A to 14D, an example wherein one outer circumferential reinforcing ring 530 is provided is shown, but the present invention is not limited to this example. For example, as shown in FIG. 14E, three divided circumferential reinforcing rings 531, 532 and 533 corresponding to three ring shaped bulk bodies 512, 514 and 516 may be provided. In this case, the second planar rings 521, 523, 525 and 527 are extended in the radial direction beyond the ring-shaped bulk bodies 512, 514, 516 so that the outer diameters of the second planar rings 521, 523, 525, 527 are aligned with the outer diameters of the outer circumferential reinforcing rings 531, 532 and 533.

(Sixth Embodiment)

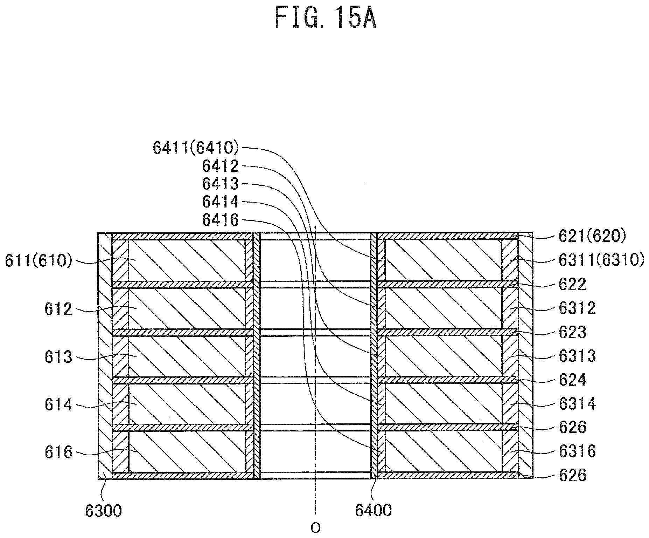

Next, the stack according to the sixth embodiment will be described with reference to FIGS. 15A to 15C. FIGS. 15A to 15C shows partial cross-sectional views taken along the central axis of the stack 600 according to the sixth embodiment.

The bulk magnet 600, which is the stack according to the sixth embodiment, comprises a ring-shaped bulk body 610, a second planar ring 620, an outer circumferential reinforcing ring 6300, a second outer circumferential reinforcing ring 6310, an inner circumferential reinforcing ring 6400 and a second inner circumferential reinforcing ring 6410. In the example shown in FIG. 15A, five ring-shaped bulk bodies 611-615 are provided as the ring-shaped bulk body 610, and six second planar rings 621-626 are provided as the second planar ring 620.

Compared with the first to fifth stacks, the bulk magnet 600 which is the sixth stack is different in that the outer circumferential end portion of the second planar ring 620 is bonded by the second outer circumferential reinforcing ring and the outer circumferential reinforcing ring and the inner circumferential end portion of the second planar ring 620 bonded by the second inner circumferential reinforcing ring and the inner circumferential reinforcing ring. Here, since the second outer circumferential reinforcing ring, the outer circumferential reinforcing ring, the second inner circumferential reinforcing ring and the inner circumferential reinforcing ring are made of metal, they can be firmly connected to the metal second planar ring with solder or the like. Therefore, the ring-shaped bulk bodies 611-615 can be firmly connected from the lateral and the upper and lower surfaces by a double structure of the second inner circumferential reinforcing ring and the inner circumferential reinforcing ring, and of the second outer circumferential reinforcing ring and the outer circumferential reinforcing ring. By this effect, the ring-shaped bulk body 610 can be firmly bonded to the surrounding second planar ring, the second inner circumferential reinforcing ring and the second circumferential reinforcing ring, and has a remarkable effect of suppressing cracking.

Further, by using a material having a high thermal conductivity for the second planar ring 620, the double structure of the second inner circumferential reinforcing ring 6410 and the inner circumferential reinforcing ring 6400, the double structure of the outer circumferential reinforcing ring 6300 and the second circumferential reinforcing ring 6310, the occurrence of quenching can be suppressed. In this case, the second planar ring 620, the outer circumferential reinforcing ring 6300 and the second outer circumferential reinforcing ring 6310 can be configured similarly to the first stack described above. For the second inner circumferential reinforcing ring 6410 and the inner circumferential reinforcing ring 6400, for example, a material containing a metal having a high thermal conductivity such as copper, aluminum, silver or the like as a main component is used in order to enhance the quench suppressing effect. The thermal conductivity of the second inner circumferential reinforcing ring 6410 and the inner circumferential reinforcing ring 6400 having a high thermal conductivity is desirably 20W/(m·K) or more, and more desirably 100 W/(m·K) or more at a temperature range of 20K to 70K at which temperature a strong magnetic field can be stably generated by a freezer or the like, from the viewpoint of the transfer and absorption of heat generated in the superconducting material.

Further, the second inner circumferential reinforcing ring 6410 and the inner circumferential reinforcing ring 6400 may be formed by arranging a plurality of rings concentrically. That is, one second inner circumferential reinforcing ring 6410 and one inner circumferential reinforcing ring 6400 as a whole are formed so that the circumferential surfaces of the opposing rings are brought into contact with each other. In this case, at least one of the materials constituting the second inner circumferential reinforcing ring 6410 and the inner circumferential reinforcing ring 6400 may have a thermal conductivity of 20 W / (m- K) or more.

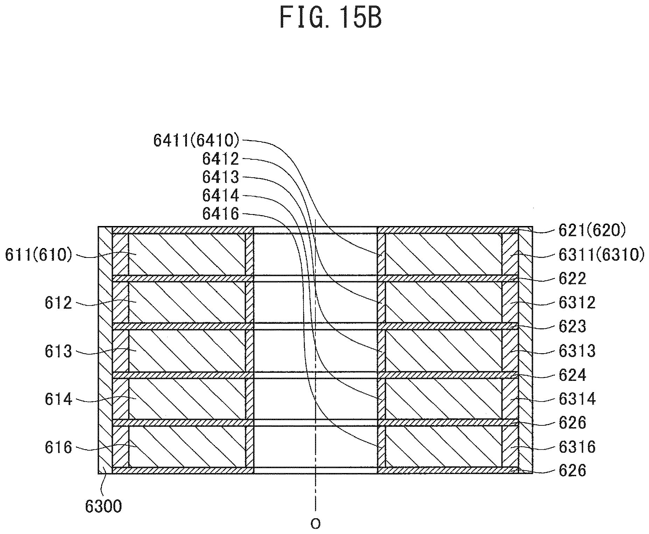

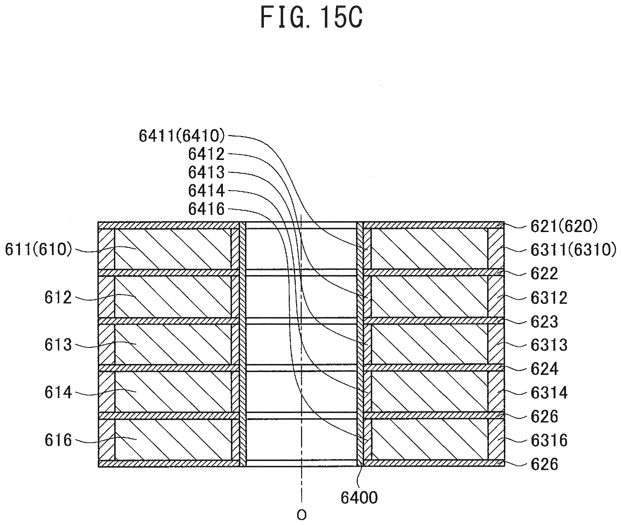

FIG. 15B shows an example of a case where the outer circumferential end portion of the second planar ring is bonded on the lateral surface and the upper and lower surfaces by a double ring structure only in the outer circumference as a modified example of FIG. 15A. This is because the inner peripheral end portion of the second planar ring may be bonded only on its upper and lower surfaces by the inner circumferential reinforcing ring, for example, in the case where it is necessary to ensure the inner diameter in terms of design. Similarly, FIG. 15C shows an example of a case where the inner circumferential end portion of the second planar ring is bonded on the lateral surface and the upper and lower surfaces by a double ring structure only in the inner circumference. This is because the outer peripheral end portion of the second planar ring may be bonded only on its upper and lower surfaces by the outer circumferential reinforcing ring, for example, in the case where the selection of the outer diameter is limited in terms of design.

(Seventh Embodiment)

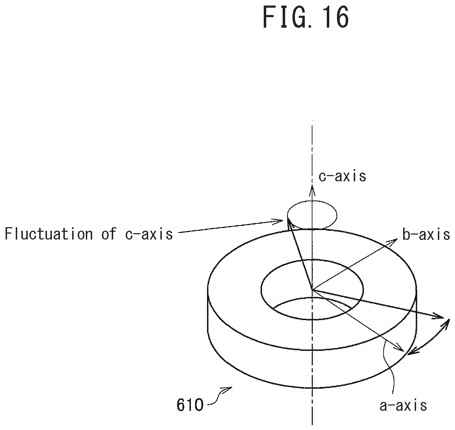

Next, the stack according to the seventh embodiment will be described with reference to FIG. 16. FIG. 16 is an explanatory diagram showing the fluctuation of the crystallographic orientation of the ring-shaped bulk body 610.

Since the ring-shaped bulk body 610 is a monocrystalline material, the anisotropy of the crystal orientation appears as disturbance of the captured magnetic flux density distribution (deviation from axial symmetry). In order to average the anisotropy of this crystal orientation, the ring-shaped bulk bodies 610 may be layered while shifting the crystal orientation of the ring-shaped bulk bodies 610.

When layering a plurality of ring-shaped bulk bodies 610, with respect to the relative crystal axis, it is preferable to arrange them so that the c-axis direction substantially coincides with the inner circumferential axis of each ring and at the same time shift the orientation of the a-axis. The ring-shaped bulk material 610 in which $RE_2BaCuO_5$ is finely dispersed in the monocrystalline $RE_1Ba_2Cu_3O_y$ generally has fluctuation in the crystal orientation of the monocrystalline

$RE_1 Ba_2 Cu_3 O_y$. The magnitude of the fluctuation in the c-axis direction is about $\pm$ 15°. Herein, the fact that the c-axis direction substantially coincides with the inner peripheral axis of each ring means that the deviation of the monocrystalline crystal orientation is about $\pm$ 15°. Although the angle of shifting the a-axis depends on the number of layering, it is desirable that the angle is not quadruple symmetry, such as 180°, 90° or the like.

In this way, by layering the ring-shaped bulk bodies 610 while shifting the crystal orientation of the ring-shaped bulk bodies 610, the anisotropy of the crystal orientation can be averaged.

(Eighth Embodiment)

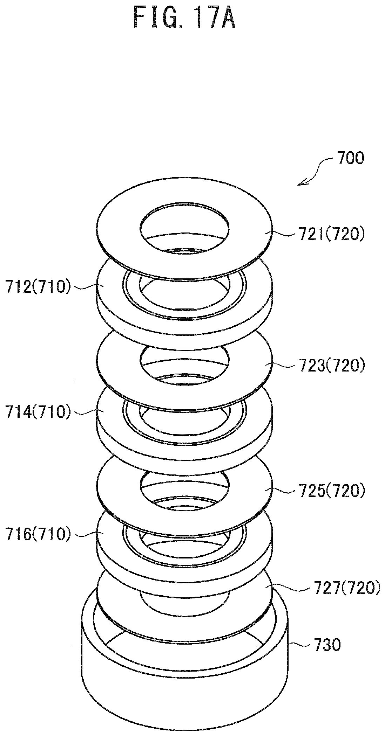

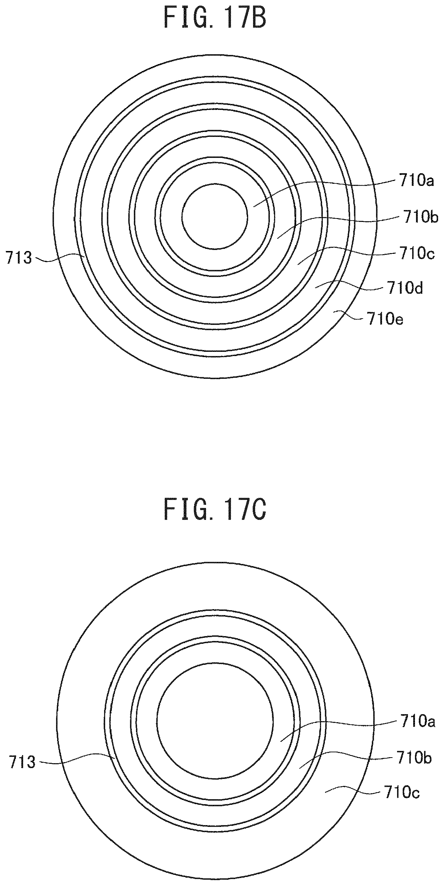

Next, the stack according to the eighth embodiment will be described with reference to FIGS. 17A to 17D. FIG. 17A is a schematic exploded perspective view showing an example of the stack according to the eighth embodiment. FIGS. 17B to 17D shows plan views of configuration examples of the stack of the ring-shaped bulk bodies 710 according to the eighth embodiment.

As compared to the first to seventh stacks, the bulk magnet 700 which is a stack according to the eighth embodiment is different in that the oxide superconducting bulk body 710 has a multiple ring structure in the radial direction. The multiple ring structure is not a single ring in the radial direction but a structure in which a plurality of rings are concentrically arranged. For example, as shown in FIG. 17B, the ring-shaped bulk body 710 has ring shaped bulk bodies 710a-710e having different inner and outer diameters and substantially the same radial widths, with a predetermined gap 713 in the radial direction, which may be a concentrically arranged quintuple ring structure.

Further, as shown in FIG. 17C, the ring-shaped bulk body 710 may be a concentrically arranged quadruple ring structure, in which the ring-shaped bulk bodies 710a-710c having different inner and outer diameters are comprised with a predetermined gap 713 in the radial direction. In this case, the radial width of the ring-shaped bulk body 710c may be larger than the radial width of the other ring-shaped bulk bodies 710a and 710b. The width of each ring is a design matter.

By layering the ring-shaped bulk bodies 710 having such a multiple ring structure, the ring-shaped bulk bodies 710 has a tendency that a quadruple symmetry is slightly reflected also in the superconducting current distribution due to crystal growth accompanying quadruple symmetry. However, by forming a concentric multiple ring, there is an effect that brings the flow path of superconducting current induced by magnetization close to axisymmetric one. This effect improves the uniformity of the captured magnetic field. The bulk magnet 700 having such characteristics is suitable for NMR and MRI application, particularly where a high magnetic field uniformity is required.

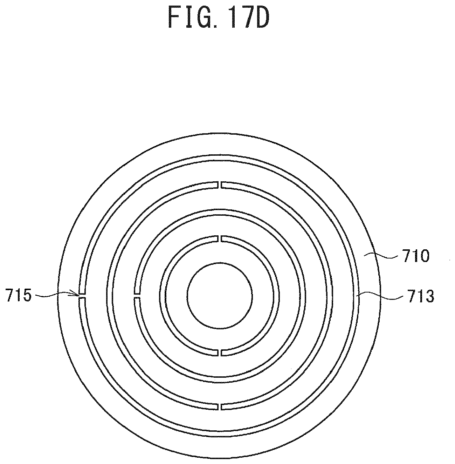

Further, as shown in FIG. 17D, for example, the ring-shaped bulk body 710 can be formed by forming concentric circular arc-shaped gaps 713 in one ring and forming a plurality of seams 715 in the circumferential direction of the gap 713 on the same circumference By doing so, the assembling work of the bulk magnet 700 can be simplified.

(Configuration D)

As another configuration of the bulk magnet structure according to the present invention, for example, in the bulk magnet structure of the configuration C shown in FIG. 9, a stack in which a ring-shaped bulk body and a second planar ring are alternately layered may be formed as a column rather than a ring on at least one of the end of the structure. That is, the stack is formed by alternately layering a columnar oxide superconducting bulk body and a columnar planar reinforcing plate. As a result, higher mechanical strength can be achieved.

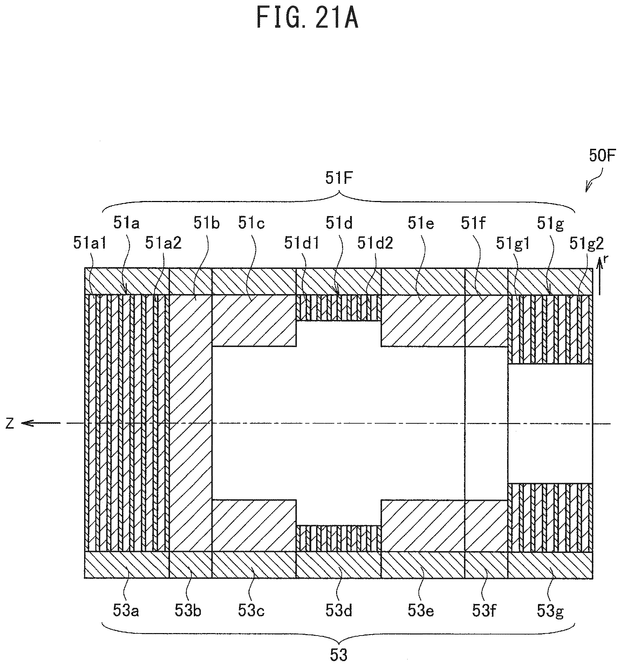

Incidentally, not only the stack on one end but also one or a plurality of bulk bodies in the stack may be formed into a columnar shape. However, a bulk body corresponding to a region where the magnetic field distribution is desired to be uniformized (magnetic field uniformization region) should be a ring-shaped bulk body. The member on one end, which is formed in a columnar shape may be formed by a stack in which a columnar superconducting bulk body and a columnar planar reinforcing plate are alternately layered, or may be formed by only the columnar oxide superconducting bulk body. Such a bulk magnet structure can be, for example, configured as shown in FIG. 21A and described later.

EXAMPLES

(Example 1)

In Example 1, the bulk magnet structure 50A shown in FIG. 6 was magnetized by the magnetization method of the bulk magnet structure according to one embodiment of the present invention described above. Specifically, as a magnetic field generator, a superconducting magnet (10T 150 made by JASTEC) having a room temperature bore diameter of 150 mm was excited to about 5T and used as an applied magnetic field for magnetization. The distribution of the applied magnetic field at this time had a shape as shown on the left side of FIG. 2. That is, it was confirmed that the magnetic field distribution had a nonuniform magnetic field distribution of about 500 ppm in a section of about 10 mm on both sides from the position where the magnetic field strength of the applied magnetic field peaks.

On the other hand, a ring-shaped bulk body having an outer diameter of 60 mm, an inner diameter of 28 mm and a thickness of 20 mm in which $Gd_2BaCuO_5$ was finely dispersed in a monocrystalline $GdBa_2Cu_3O_y$ was prepared. Two ring-shaped bulk bodies having an outer diameter of 60 mm, an inner diameter of 36 mm and a thickness of 20 mm having the same structure, two ring-shaped bulk bodies having an outer diameter of 60 mm, an inner diameter of 36 mm and a thickness of 10 mm, one ring-shaped bulk body having an outer diameter of 60 mm, an inner diameter of 44 mm and a thickness of 20 mm were prepared. An outer circumferential reinforcing ring having an outer diameter of 80 mm and an inner diameter of 60mm made of aluminum alloy (A 5104) was fitted into each ring-shaped bulk body and they were layered as shown in FIG.6 to prepare a bulk magnet structure. At this time, grease was put in the gap between the outer circumferential reinforcing ring made of aluminum and the ring-shaped bulk body, and they were adhered to each other.

The resulting bulk magnet structure was fixed on the cold head of the cooling device, and the cover of the vacuum heat insulation container was attached and then cooled to 100K. Then, the cold head portion of the cooling device was inserted into the room temperature bore of the superconducting magnet such that the center of the bulk magnet structure coincides with the center position of the applied magnetic field shown on the left side of FIG. 2. Thereafter, electricity was applied so that the center magnetic field of the superconducting magnet was about 5T to excite the superconducting magnet.

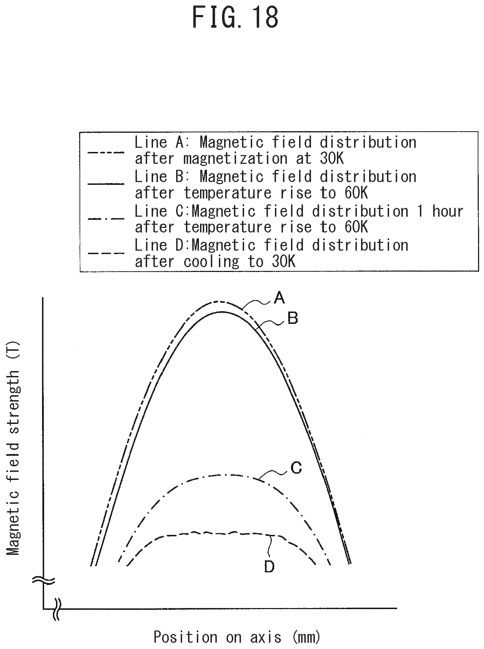

After completing the excitation of the superconducting magnet, the bulk magnet structure was cooled to 30 K. After the temperature was stabilized, the applied magnetic field of the superconducting magnet was demagnetized to zero magnetic field at 0.05 T / min and magnetization was performed (basic magnetization step). After magnetization, the cold head portion of the cooling device to which the bulk magnet structure was fixed was pulled out from the bore of the magnet, and the magnetic field distribution on the central axis of the bulk magnet structure was measured. The result is shown by line A in FIG.18. It can be confirmed that the magnetic field distribution indicated by line A very well coincided with the applied magnetic field distribution shown on the left side of FIG. 2.

Next, using a temperature controller that controls a temperature of the cooling device, the bulk magnet structure was heated to 60 K and the magnetic field distribution on the central axis was measured while the temperature was stable. The result is shown by line B in FIG. 18. From the measurement result, it was confirmed that the magnetic field strength was slightly lowered. Therefore, about 1 hour later, another measurement was again made. As shown by the line C in FIG. 18, the peak of the magnetic field strength at the center of the magnetic field distribution disappeared, and the magnetic field distribution was uniformized. It is believed that this is due to the influence of flux creep. From this result, in order to prevent the decrease of the magnetic field strength due to flux creep, the temperature was rapidly cooled to 30 K and the magnetic field distribution in the axially central portion was measured again in the state where the temperature was stabilized at 30 K. The result is shown by line D in FIG.18. It was confirmed from FIG. 18 that the magnetic field strength was uniformized such that the difference in magnetic field strength in the section of about 10 mm on both sides from the center of the applied magnetic field was within 110 ppm.

According to such a magnetization method, a bulk magnet structure having a structure where a plurality of ring-shaped bulk bodies in which $Gd_2BaCuO_5$ was finely dispersed in a monocrystalline $Gd_1Ba_2Cu_3O_y$ were layered was magnetized in the external magnetic field distribution having a uniformity of 500ppm in a section within about 10mm on the both sides from the center of the applied magnetic field. As a result, it was confirmed that the magnetic field was uniformized such that the difference in magnetic field strength in that section in the bulk magnet structure can be within 110 ppm.

(Example 2)

In Example 2, the bulk magnet structure 50B shown in FIG. 8 was magnetized by the magnetization method of the bulk magnet structure according to one embodiment of the present invention described above. Specifically, as a magnetic field generator, a superconducting magnet (10T 150 made by JASTEC) having a room temperature bore diameter of 150 mm was excited to about 5T and used as an applied magnetic field for magnetization. The distribution of the applied magnetic field at this time had a shape as shown on the left side of FIG. 2 as in Example 1.

On the other hand, two ring-shaped bulk bodies having an outer diameter of 60 mm, an inner diameter of 28 mm and a thickness of 20 mm, in which $Gd_2BaCuO_5$ was finely dispersed in a monocrystalline $GdBa_2 Cu_3O_y$, were prepared. Two ring-shaped bulk bodies having an outer diameter of 60 mm, an inner diameter of 36 mm and a thickness of 20 mm having the same structure, and two ring-shaped bulk bodies having an outer diameter of 60 mm, an inner diameter of 36 mm and a thickness of 10 mm were prepared and silver film formation treatment was performed on a surface of each of the bulk bodies. Then, each of the ring-shaped bulk bodies was solder-bonded to an outer circumferential reinforcing ring made of an aluminum alloy (A 5104) having an outer diameter of 80 mm, an inner diameter of 60 mm and a height of 20 mm or 10 mm, in which the ring-shaped bulk bodies were fitted.

Eight rings having an outer diameter of 60 mm, an inner diameter of 44 mm and a thickness of 2 mm were prepared in the same manner, and silver film formation treatment was performed on their surfaces, and the resulting bodies were alternately layered to seven NiCr ring plates having an outer diameter of 60 mm, an inner diameter of 44 mm and a thickness of 0.5 mm as a first planar ring, and the resulting stack was placed in an outer circumferential reinforcing ring made of an aluminum alloy (A 5104) having an outer diameter of 80 mm, an inner diameter of 60 mm and a height of 20 mm. At this time, the outer circumferential reinforcing ring made of aluminum alloy, the ring-shaped bulk bodies and the first planar rings made of NiCr were bonded by solder, respectively.

Each of these bulk magnets solder-connected by using these aluminum alloy circumferential reinforcing rings were layered as shown in FIG. 8 to prepare a bulk magnet structure.

The bulk magnet structure obtained by layering was fixed on the cold head of the cooling device, and the cover of the vacuum insulation container was attached and then cooled to 100K. The cold head portion of the cooling device was inserted into the room temperature bore of the magnet so that the center of the bulk magnet structure coincided with the center position of the applied magnetic field. Thereafter, energization was performed so that the central magnetic field of the magnet was excited to about 5 T.

After the excitation of the magnet was completed, the bulk magnet structure was cooled to 25 K. After the temperature was stabilized, the applied magnetic field of the magnet was demagnetized to zero magnetic field at 0.05 T/min and magnetization was performed (basic magnetization step). After magnetization, the cold head portion of the cooling device was pulled out from the bore of the magnet, and the magnetic field distribution on the central axis of the bulk magnet structure was measured. As a result, it was found that the magnetic field strength peak at the center of the magnetic field became slightly lower with respect to the applied magnetic field distribution, and thus the magnetic field was very slightly uniformized by the magnetization.

Next, using a temperature controller that controls the temperature of the cooling device, the bulk magnet structure was heated to 56 K and the magnetic field distribution on the central axis was measured while the temperature was stable. As a result, it was confirmed that the magnetic field strength was slightly lowered. As a result of measurement again about 1 hour later, due to influence of flux creep, the magnetic field strength at the center of the magnetic field was lowered and the magnetic field distribution became uniform. Therefore, in order to prevent the decrease of magnetic field strength due to flux creep, the bulk magnet structure was quickly cooled down to 30 K, and the magnetic field distribution in the axially central portion was again measured while the temperature was stabilized at 30 K. As a result, it was confirmed that the magnetic field was uniformized such that the difference in magnetic field strength in the section of about 10 mm on both sides from the center of the applied magnetic field was within 85 ppm.

According to such a magnetization method, a bulk magnetic structure having a structure wherein a plurality of ring-shaped bulk bodies in which $Gd_2BaCuO_5$ was finely dispersed in a monocrystalline $GdBa_2 Cu_3O_y$ were layered and the ring-shaped bulk bodies are layered via first planar rings was magnetized in the external magnetic distribution having uniformity of 500 ppm in the section of about 10 mm on both sides from the center of the applied magnetic field. As a result, it was confirmed that the magnetic field could be uniformized such that the difference in magnetic field strength in the same section in the bulk magnet structure was within 85 ppm.

(Example 3)

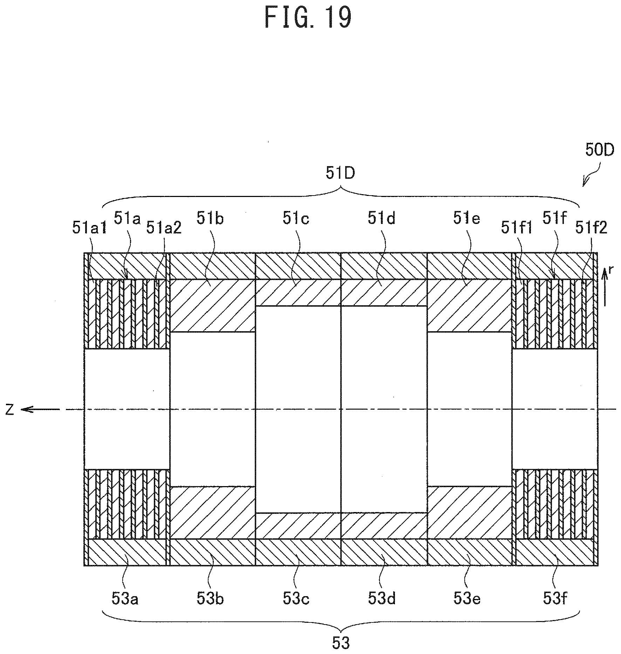

In Example 3, the bulk magnet structure 50D having the ring-shaped bulk body portion 51D shown in FIG. 19 was magnetized by the magnetization method of the bulk magnet structure according to one embodiment of the present invention described above. Specifically, as a magnetic field generator, a superconducting magnet (10T 150 made by JASTEC) having a room temperature bore diameter of 150 mm was excited to about 6T and used as an applied magnetic field for magnetization. The distribution of the applied magnetic field at this time had a shape as shown on the left side of FIG. 2 as in Example 1.

Fourteen ring-shaped bulk bodies having an outer diameter of 60 mm, an inner diameter of 28 mm and a thickness of 2 mm, in which $Gd_2BaCuO_5$ was finely dispersed in a monocrystalline $GdBa_2Cu_3O_y$ were prepared for forming a ring-shaped bulk body portion 51D shown in FIG. 19. These correspond to the ring-shaped bulk bodies 51a1 and 51f1 of FIG. 19. Two ring-shaped bulk bodies having an outer diameter of 60 mm, an inner diameter of 36 mm and a thickness of 20 mm having the same structure, and two ring-shaped bulk bodies having an outer diameter of 60 mm, an inner diameter of 44 mm and a thickness of 20 mm were prepared. These correspond to the ring-shaped bulk bodies 51b and 51e in FIG. 19 and the central ring-shaped bulk bodies 51c and 51d, respectively. In addition, silver film formation treatment was performed on the surface of each of the ring-shaped bulk bodies.

Next, a reinforced bulk magnet was produced using a ring-shaped bulk body having an outer diameter of 60 mm, an inner diameter of 28 mm and a thickness of 2 mm. For preparing the bulk magnet, twelve SUS 316L plates having an outer diameter of 60 mm, an inner diameter of 27.8 mm and a thickness of 0.6 mm, and four SUS 316L plates having an outer diameter of 80 mm, an inner diameter of 27.8 mm and a thickness of 0.8 mm were used as two kinds of second planar rings having different outer diameters were prepared. Incidentally, since FIG. 19 shows a rough outline, the two kinds of second planar rings having different outer diameters are represented by the same shape and are shown as second planar rings 51a2 and 51f2.

Two outer circumferential reinforcing rings made of an aluminum alloy (A 5104) having an outer diameter of 80 mm, an inner diameter of 60 mm and a height of 18.5 mm were prepared, and seven ring-shaped bulk bodies 51a1 and 51f1 having a thickness of 2.0 mm and six second planar rings 51a2 and 51f2 having an outer diameter of 60 mm were alternately layered in the outer circumferential ring and second planar rings made of a SUS 316 L plate having an outer diameter of 80 mm, an inner diameter of 27.8 mm and a thickness of 0.8 mm were arranged at both ends of the resulting stacks to form sets of stacks 51a and 51f. The outer circumferential reinforcing ring corresponds to the outer circumferential reinforcing rings 53a and 53f in FIG. 19. The second planar ring having an outer diameter of 80 mm was disposed so as to cover both end surfaces of the outer circumferential reinforcing rings 53a and 53f. Then, ring-shaped bulk bodies in one outer circumferential reinforcing ring made of aluminum alloy (A 5104) and second planar rings made of SUS 316 L were bonded by soldering. In this way, two bulk magnets disposed at both ends of the bulk magnet structure 50D were fabricated.

On the other hand, the outer circumferential rings 53b, 53c, 53d and 53e made of an aluminum alloy (A 5104) having an outer diameter of 80 mm, an inner diameter of 60 mm and a height of 20.0 mm were bonded to two ring-shaped bulk bodies 51b and 51e having an outer diameter of 60 mm, an inner diameter of 36 mm and a thickness of 20 mm and two ring-shaped bulk bodies 51c and 51d having an outer diameter of 60 mm, an inner diameter of 44 mm and a thickness of 20 mm, respectively, by solder bonding to prepare four bulk magnets.

The six bulk magnets thus obtained were layered as shown in FIG. 19 to prepare a bulk magnet structure 50D having a ring-shaped bulk body portion 51D.

The bulk magnet structure 50D obtained by layering was fixed on the cold head of the cooling device and cooled to 100K after the cover of the vacuum heat insulation container was attached. The cold head portion of the cooling device was inserted into the room temperature bore of the magnet so that the center of the bulk magnet structure 50D coincided with the center position of the applied magnetic field. Thereafter, electricity was applied so that the center magnetic field of the magnet became about 6T to excite the magnet. After magnet excitation was completed, the bulk magnet structure 50D was cooled to 25 K. After the temperature was stabilized, the applied magnetic field of the magnet was demagnetized to zero magnetic field at 0.05 T/min, and magnetization process was performed. After magnetization, the cold head portion of the cooling device was pulled out from the bore of the magnet, and the magnetic field distribution on the central axis of the bulk magnet structure 50D was measured. As a result, it was found that a magnetic field distribution of approximately the same level was obtained with respect to the applied magnetic field distribution.

Next, using the temperature controller 30 for controlling the temperature of the cooling device, the temperature of the bulk magnet structure 50D was raised to 52 K. The magnetic field distribution on the central axis was measured while the temperature was stabilized. As a result, it was confirmed that the magnetic field strength was slightly lowered. By the measurement again about 1 hour later, due to the influence of flux creep, the magnetic field strength at the center of the magnetic field was decreased, and the magnetic field distribution became uniform. Then, in order to prevent the decrease of magnetic field strength due to flux creep, the temperature was quickly lowered to 30 K, and the magnetic field distribution in the axially central portion was again measured while the temperature was stabilized at 30 K. As a result, it was confirmed that the magnetic field was uniformized such that the difference in magnetic field strength in the section of about 10 mm on both sides from the center of the applied magnetic field was within 45 ppm.

According to such a magnetization method, a bulk magnet structure wherein a plurality of ring-shaped bulk bodies in which $Gd_2BaCuO_5$ was finely dispersed in a monocrystalline $Gd_1Ba_2Cu_3O_y$ were layered, and bulk magnets reinforced by using second planar rings were disposed at the ends of the bulk magnet structure 50D, would not be cracked even in a strong magnetic field of 6T. It was confirmed that, by magnetizing in the external magnetic field having uniformity of 500 ppm in the section of about 10 mm on both sides from the center of the applied magnetic field, the magnetic field could be uniformized such that the difference in magnetic field strength in the same section in the bulk magnet structure 50D was within 45 ppm.

(Example 4)

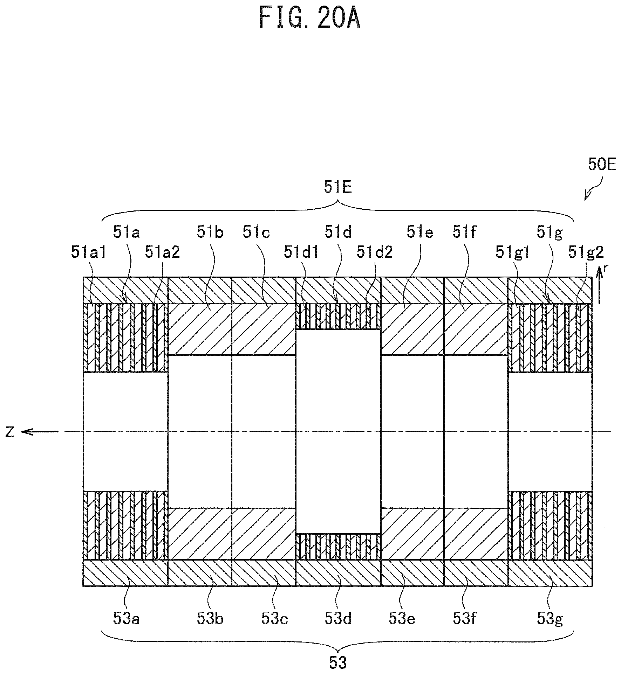

In Example 4, the bulk magnet structure 50E shown in FIG. 20A was magnetized by the magnetization method of the bulk magnet structure according to one embodiment of the present invention described above. Specifically, as a magnetic field generator, a superconducting magnet (10T 150 made by JASTEC) having a room temperature bore diameter of 150 mm was excited to about 7T and used as an applied magnetic field for magnetization. The distribution of the applied magnetic field at this time had a shape as shown on the left side of FIG. 2 as in Example 1.

Fourteen ring-shaped bulk bodies having an outer diameter of 60 mm, an inner diameter of 29 mm and a thickness of 2 mm, in which $Eu_2BaCuO_5$ was finely dispersed in a monocrystalline $EuBa_2Cu_3O_y$ were prepared. Four ring-shaped bulk bodies having an outer diameter of 60 mm, an inner diameter of 35 mm and a thickness of 15 mm having the same structure, eight ring-shaped bulk bodies having an outer diameter of 60 mm, an inner diameter of 44 mm and a thickness of 2 mm were prepared, and silver film formation treatment was performed on the surface of each the ring-shaped bulk bodies.

Next, reinforced bulk magnets were produced using ring-shaped bulk bodies having an outer diameter of 60 mm, an inner diameter of 29 mm and a thickness of 2 mm. In preparing the bulk magnet, sixteen SUS 316L plates having an outer diameter of 64 mm, an inner diameter of 26 mm and a thickness of 0.5 mm were prepared as the second planar ring. Two rings made of SUS 316L having an outer diameter of 80 mm, an inner diameter of 64 mm and a height of 19 mm were prepared as the outer circumferential reinforcing ring. Fourteen rings made of Cu having an outer diameter of 64 mm, an inner diameter of 60 mm and a height of 2 mm were prepared as the second outer circumferential reinforcing ring. Fourteen rings made of SUS 316L having an outer diameter of 29 mm, an inner diameter of 26 mm and a height of 2 mm were prepared as the second inner circumferential reinforcing ring. Two rings made of an aluminum alloy (A5104) having an outer diameter of 26 mm, an inner diameter of 24 mm and a height of 19 mm were prepared as the inner circumferential reinforcing ring. Then, the second outer circumferential reinforcing rings made of Cu in one outer circumferential reinforcing ring made of SUS 316L, the ring-shaped bulk bodies, the second planar rings made of SUS 316L, the second inner circumferential reinforcing rings made of SUS 316L and the inner circumferential reinforcing ring made an aluminum alloy (A 5104) were bonded by solder, respectively.

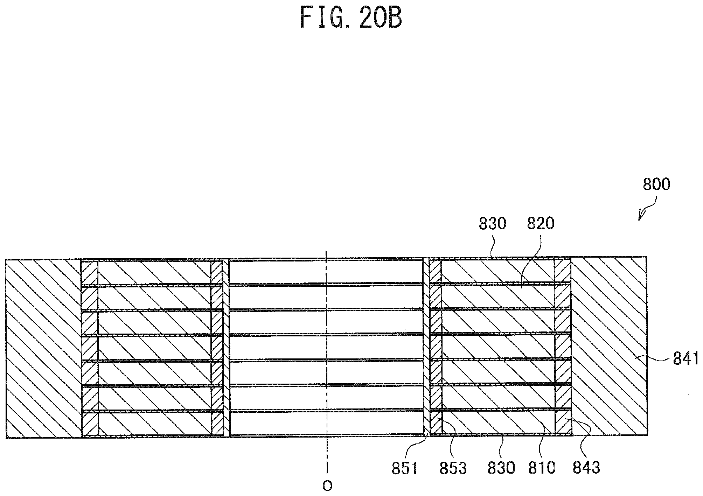

By arranging these as shown in FIG. 20A, two bulk magnets arranged at the end portions of the bulk magnet structure 50E were fabricated. Two bulk magnets 800 arranged at the end portions of the bulk magnet structure 50E shown in FIG. 20B are ones shown in detail as a bulk magnet comprising the stack 51a and the outer circumferential reinforcing ring 53a, and a bulk magnet comprising the stack 51g and the outer circumferential reinforcing ring 53g of FIG. 20A. The bulk magnet 800 includes ring-shaped bulk bodies 810 having an outer diameter of 60 mm, an inner diameter of 29 mm and a thickness of 2 mm, second planar rings 820 and 830, an outer circumferential reinforcing ring 841, second outer circumferential reinforcing rings 843, an inner circumferential reinforcing ring 851 and second inner circumferential reinforcing rings 853.

Further, regarding the eight rings 51d1 having an outer diameter of 60 mm, an inner diameter of 44 mm and a thickness of 2 mm shown in FIG. 20A, the surface of the ring 51d1 was subjected to silver film formation treatment and nine NiCr ring plates having an outer diameter of 60 mm, an inner diameter of 43.5 mm and a thickness of 0.45mm were alternately layered with the first planar ring 51d2 to form a ring-shaped bulk body 51d, which was disposed in an outer circumferential reinforcing ring 53d made of an aluminum alloy (A 5104) having an outer diameter of 80 mm, an inner diameter of 60 mm and a height of 20 mm. In this case, the ring 51 d1 and the first planar ring made of NiCr, the outer circumferential reinforcing ring 53d made of an aluminum alloy and the ring-shaped bulk bodies 51d were bonded by solder, respectively.

For the four ring-shaped bulk bodies 51b, 51c, 51e and 5 lf having an outer diameter of 60 mm, an inner diameter of 35 mm and a thickness of 15 mm, they were arranged in the outer circumferential reinforcing rings 53b, 53c, 53e and 53f having an aluminum alloy (A 5104) having an outer diameter of 80 mm, an inner diameter of 60 mm and a height of 15.0 mm, respectively by solder connection to prepare four bulk magnets.

The seven bulk magnets thus obtained were layered as shown in FIG. 20A to prepare a bulk magnet structure 50E.

The bulk magnet structure 50 E obtained by layering was fixed on the cold head of the cooling device and cooled to 100 K after attaching the cover of the vacuum heat insulation container. The cold head portion of the cooling device was inserted into the room temperature bore of the magnet such that the center of the bulk magnet structure 50E coincided with the center position of the applied magnetic field. Thereafter, electricity was applied so that the center magnetic field of the magnet was about 7T to excite the magnet. After the excitation of the magnet was completed, the bulk magnet structure 50 E was cooled to 25 K. After the temperature was stabilized, the applied magnetic field of the magnet was demagnetized to zero magnetic field at 0.05 T/ min, and the magnetization process was performed. After magnetization, the cold head portion of the cooling device was pulled out from the bore of the magnet, and the magnetic field distribution on the central axis of the bulk magnet structure 50E was measured. As a result, it was found that a magnetic field distribution of approximately the same level was obtained with respect to the applied magnetic field distribution.

Next, using a temperature controller that controls the temperature of the cooling device, the temperature of the bulk magnet structure 50E was raised to 51K and the magnetic field distribution on the central axis was measured while the temperature was stable. As a result, it was confirmed that the magnetic field strength was slightly lowered. About 1 hour later, measurement was again made. As a result, due to the influence of flux creep, the magnetic field strength at the center of the magnetic field was lowered so that the magnetic field distribution became uniform. Then, in order to prevent the decrease of magnetic field strength due to flux creep, the temperature was quickly lowered to 35 K, and the magnetic field distribution in the axially central portion was measured again while the temperature was stabilized at 35K. As a result, it was confirmed that the magnetic field was uniformized such that the difference in magnetic field strength in the section of about 10 mm on both sides from the center of the applied magnetic field was within 50 ppm.

According to such a magnetization method, a bulk magnet structure wherein a plurality of ring-shaped bulk bodies in which $Eu_2BaCuO_5$ was finely dispersed in a monocrystalline $Eu_1Ba_2Cu_3O_y$ were layered, and bulk magnets reinforced by using second planar rings were disposed at the ends of the bulk magnet structure 50E, would not be cracked even in a strong magnetic field of 7T. It was confirmed that, by magnetizing in the external magnetic field having uniformity of 500 ppm in the section of about 10 mm on both sides from the center of the applied magnetic field, the magnetic field could be uniformized such that the difference in magnetic field strength in the same section in the bulk magnet structure 50E was within 50 ppm.

(Example 5)

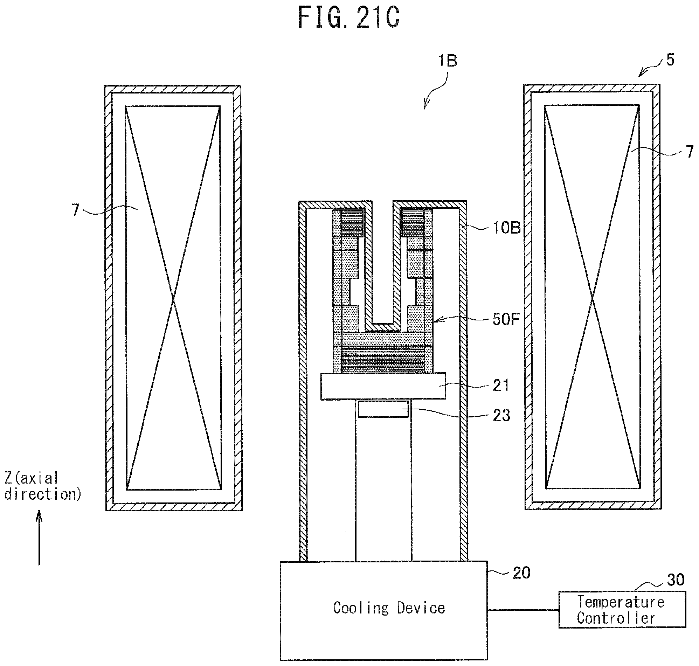

In Example 5, the bulk magnet structure 50F shown in FIG. 21A was magnetized by the magnetization method of the bulk magnet structure according to one embodiment of the present invention described above. Specifically, the magnetization was carried out by a magnetization system 1B as shown in FIG. 21C, comprising a magnetic field generator 5, a vacuum heat insulation container 10B in which the bulk magnet structure 50F is housed, a cooling device 20 and a temperature controller 30. The magnetization system 1B shown in FIG. 21C has the same configuration as the magnetization system 1 shown in FIG. 1. As shown in FIG. 21C, the bulk magnet structure 50F is placed so that the columnar bulk magnet side is in contact with the cold head 21. As a magnetic field generator, a superconducting magnet (10T 150 made by JASTEC) having a room temperature bore diameter of 150 mm was excited to about 6T and used as an applied magnetic field for magnetization. The distribution of the applied magnetic field at this time had a shape as shown on the left side of FIG. 2 as in Example 1.

Seven ring-shaped bulk bodies having an outer diameter of 60 mm, an inner diameter of 29 mm and a thickness of 2 mm, in which $Gd_2BaCuO_5$ was finely dispersed in a monocrystalline $GdBa_2Cu_3O_y$ were prepared. In addition, one ring-shaped bulk body having a similar structure and having an outer diameter of 60 mm, an inner diameter of 35 mm and a thickness of 10 mm, and two ring-shaped bulk bodies having a similar structure and having an outer diameter of 60 mm, an inner diameter of 35 mm and a thickness of 20 mm were prepared. Further, one columnar oxide superconducting bulk body having a similar structure and having an outer diameter of 60 mm and a thickness of 10 mm was fabricated.

Eight ring-shaped bulk bodies having an outer diameter of 60 mm, an inner diameter of 44 mm and a thickness of 2 mm were prepared, and the surface of each of the ring-shaped bulk bodies was subjected to silver film formation treatment. Further, seven columnar oxide superconducting bulk bodies having the similar structure and having an outer diameter of 60 mm and a thickness of 2 mm were prepared.

Next, a reinforced bulk magnet was prepared using the ring-shaped bulk bodies having an outer diameter of 60 mm and an inner diameter of 29mm and a thickness of 2 mm. In preparing the bulk magnet, eight SUS 314 plates having an outer diameter of 64 mm, an inner diameter of 26 mm and a thickness of 0.5 mm were prepared as the second planar ring. One ring made of SUS 314 having an outer diameter of 80 mm, an inner diameter of 64 mm and a height of 19 mm was prepared as the outer circumferential reinforcing ring. Seven rings made of Cu having an outer diameter of 64 mm, an inner diameter of 60 mm and a height of 2 mm was prepared as the second outer circumferential reinforcing ring. Seven rings made of SUS 314 having an outer diameter of 29 mm, an inner diameter of 26 mm and a height of 2 mm were prepared as the second inner circumferential reinforcing ring. One ring made of an aluminum alloy (A 5104) having an outer diameter of 26 mm, an inner diameter of 24 mm and a height of 19 mm was prepared as the inner circumferential reinforcing ring. In this case, the second outer circumferential reinforcing rings made of Cu in one outer circumferential reinforcing ring made of SUS 314, the ring-shaped bulk bodies, the second planar rings made of SUS 314, the second inner circumferential reinforcing rings made of SUS 314, and the inner circumferential reinforcing ring made of an aluminum alloy (A 5104) were bonded with solder, respectively. In this way, one bulk magnet to be arranged at the end of the bulk magnet structure was prepared.

Also, a reinforced bulk magnet was produced using a columnar oxide superconducting bulk body having an outer diameter of 60 mm and a thickness of 2 mm. In preparing the bulk magnet, eight SUS 314 plates having an outer diameter of 64 mm and a thickness of 0.5 mm were prepared as planar reinforcing plates. In addition, one ring made of SUS 314 having an outer diameter of 80 mm, an inner diameter of 64 mm and a height of 19 mm was prepared as the outer circumferential reinforcing ring. Seven rings made of Cu having an outer diameter of 64 mm, an inner diameter of 60 mm and a height of 2 mm were prepared as the second outer circumferential reinforcing ring.

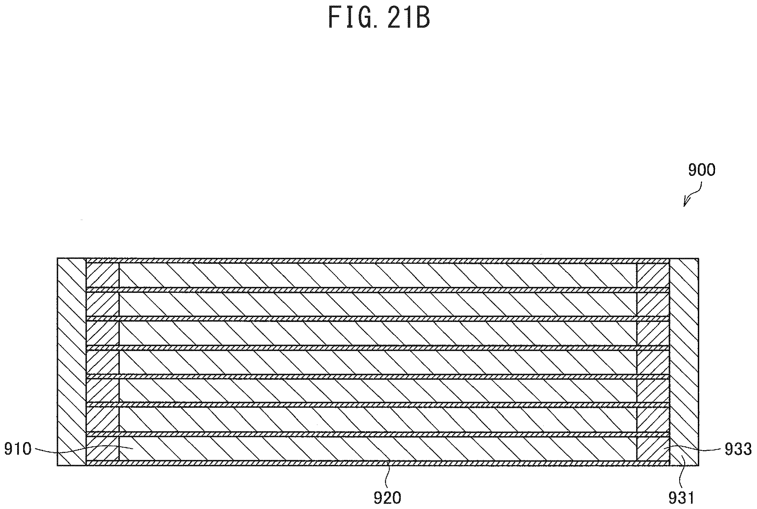

By arranging these as shown in FIG. 21B, one columnar bulk magnet to be placed at the end of the bulk magnet structure was produced. The columnar bulk magnet 900 placed at one end of the bulk magnet structure shown in FIG. 21B is a detailed view of the bulk magnet comprising the stack 51a and the outer reinforcing ring 53a in FIG. 21A. The bulk magnet 900 is composed of a columnar oxide superconducting bulk body 910 having an outer diameter of 60 mm and a thickness of 2 mm, a planar reinforcing plate 920, an outer circumferential reinforcing ring 931 and a second outer circumferential reinforcing ring 933.

Further, regarding the eight rings 51d1 having an outer diameter of 60 mm, an inner diameter of 42 mm and a thickness of 2 mm shown in FIG. 21A, the surface of the ring 51d1 was subjected to silver film formation treatment, nine ring plates made of SUS 316 having an outer diameter of 60 mm, an inner diameter of 43.5 mm and a thickness of 0.45 mm were alternately layered with the first planar rings 51d2 to form a ring-shaped bulk body 51d, which was disposed in an outer circumferential reinforcing ring 53d made of an aluminum alloy (A 5104) having an outer diameter of 80 mm, an inner diameter of 60 mm and a height of 20 mm. At this time, the ring 51d1, the first planar ring 51d2 made of NiCr, the outer circumferential reinforcing ring 53d made of an aluminum alloy and the ring-shaped bulk body 51d were bonded by solder, respectively.

The seven bulk magnets thus obtained were layered as shown in FIG. 21A to prepare a bulk magnet structure 50F.

The bulk magnet structure 50F obtained by layering was fixed on the cold head 21 of the cooling device 20 shown in FIG. 21C, and the cover of the vacuum heat insulation container 10B was attached and then cooled to 100K. The cold head portion 21 of the cooling device 20 was inserted into the room temperature bore of the magnet so that the center of the bulk magnet structure 50F coincided with the center position of the applied magnetic field. Thereafter, electricity was applied so that the center magnetic field of the magnet became about 6T to excite the magnet. After completing magnet excitation, the bulk magnet structure 50 F was cooled to 25 K. After the temperature was stabilized, the applied magnetic field of the magnet was demagnetized to zero magnetic field at 0.05 T/min and magnetization process was performed. After magnetization, the cold head portion of the cooling device was pulled out from the bore of the magnet, and the magnetic field distribution on the central axis of the bulk magnet structure 50F was measured. As a result, it was found that a magnetic field distribution of approximately the same level was obtained with respect to the applied magnetic field distribution.

Next, using a temperature controller 30 that controls the temperature of the cooling device 20, the temperature of the bulk magnet structure 50F was raised to 53 K, and the magnetic field distribution on the central axis was measured while the temperature was stabilized. As a result, it was confirmed that the magnetic field strength was slightly lowered. About 1 hour later, measurement was again performed. Due to the influence of flux creep, the magnetic field strength at the center of the magnetic field was decreased such that the magnetic field distribution became uniform. Therefore, in order to prevent the decrease of magnetic field strength due to flux creep, the temperature was quickly lowered to 30 K, and the magnetic field distribution in the axially central portion was again measured while the temperature was stabilized at 30 K. As a result, it was confirmed that the magnetic field was uniformized such that the difference in magnetic field strength in the section of about 10 mm on both sides from the center of the applied magnetic field was within 80 ppm.

According to such a magnetization method, a bulk magnet structure wherein a plurality of ring-shaped bulk bodies in which $Gd_2BaCuO_5$ was finely dispersed in a monocrystalline $Gd_1Ba_2Cu_3O_y$ were layered, and bulk magnets reinforced by using second planar rings were disposed at the ends of the bulk magnet structure 50F, would not be cracked even in a strong magnetic field of 6T. It was confirmed that, by magnetizing in the external magnetic field having uniformity of 500 ppm in the section of about 10 mm on both sides from the center of the applied magnetic field, the magnetic field could be uniformized such that the difference in magnetic field strength in the same section in the bulk magnet structure 50F was within 80 ppm.

As described above, the bulk magnet structure 50F of Example 5 shown in FIG. 21A was magnetized by a magnetization system 1B comprising a magnetic field generator 5, a vacuum heat insulation container 10B in which the bulk magnet structure 100 is housed, a cooling device 20 and a temperature controller 30 as shown in FIG. 21C. In this case, the bulk magnet structure 50F is placed on the cold head 21 so that the reinforced bulk magnet formed by using the columnar oxide superconducting bulk body comes into contact with the cold head. Further, in the present invention, the position of the columnar oxide superconducting bulk body is not particularly limited, but when it is used in NMR or the like, as shown in FIG. 21C, a ring-shaped bulk body is disposed on the sample insertion side, and a columnar oxide superconducting bulk body is preferably disposed on the opposite side, which is the side of the cold head 21.

(Comparative Example 1)

The magnetization process was performed and the magnetic field distribution was measured under the same conditions as in Example 1 except that the bulk magnet structure was constructed without using an outer circumferential reinforcing ring. As a result, cracking occurred at least at the center portion 51d, and the captured magnetic flux density at the center portion was lowered to about 2T. From this result, it was confirmed that without an outer circumferential reinforcing ring, it was difficult even to capture a strong magnetic field of 5T level.

(Comparative Example 2)

The magnetization process was performed and the magnetic field distribution was measured under the same conditions as in Example 1 except that the inner diameter of 51d at the center of FIG. 6 was set to be the same as that of 51c and 51e. As a result, cracking occurred at least at the center portion 51d, and the captured magnetic flux density at the center portion was lowered to about 2T. From this result, it was confirmed that without an outer circumferential reinforcing ring, it was difficult even to capture a strong magnetic field of 5T level.

Although the preferred embodiments of the present invention have been described in detail with reference to the accompanying drawings, the present invention is not limited to such examples. Those having ordinary knowledge in the technical field to which the present invention belongs can clearly conceives various changes or modifications within the scope of the technical idea described in the claims. It is understood that these are naturally also within the technical scope of the present invention.

REFERENCE SIGNS LIST

| | |
|---|---|
| 50A, 50B, 50C, 50D, 50E and 50 F | bulk magnet structure |
| 51d | stack |
| 51d2 | first planar ring |
| 100, 200, 300, 400, 500, 600 and 700 | bulk magnet |
| 110, 210, 310, 410, 510, 610 and 710 | ring-shaped oxide superconducting bulk body |
| 120, 220, 320, 420, 520 and 620 | second planar ring |
| 130, 230, 330, 430, 530 and 6300 | outer circumferential reinforcing ring |
| 540 and 6400 | inner circumferential reinforcing ring |
| 6310 | second outer circumferential reinforcing ring |
| 6410 | second inner circumferential reinforcing ring |
| 910 | Columnar oxide superconducting bulk body |
| 920 | planar reinforcing plate |

**Claims**

1.  A bulk magnet structure comprising

    a plurality of ring-shaped oxide superconducting bulk bodies and
    at least one outer circumferential reinforcing ring fitted to cover the outer circumferential surface of said plurality of the layered ring-shaped oxide superconducting bulk bodies,
    wherein at least one of the ring-shaped oxide superconducting bulk body has an inner diameter that is larger than an inner diameter of a ring-shaped oxide superconductive bulk body adjacent to the above oxide superconductive bulk body.

2.  A bulk magnet structure comprising

    a plurality of ring-shaped oxide superconducting bulk bodies and
    at least one outer circumferential reinforcing ring fitted to cover the outer circumferential surface of said plurality of the layered ring-shaped oxide superconducting bulk bodies,
    wherein at least one of the ring-shaped oxide superconducting bulk body forms a stack in which the ring-shaped oxide superconducting bulk body and a first planar ring are alternately arranged.

3.  A bulk magnet structure comprising

    a plurality of oxide superconducting bulk bodies and
    at least one outer circumferential reinforcing ring fitted to cover the outer circumferential surface of said plurality of the layered oxide superconducting bulk bodies,
    wherein said plurality of oxide superconducting bulk bodies comprise at least one ring-shaped oxide superconducting bulk body, and are configured by layering the ring-shaped oxide superconducting bulk body or a columnar oxide superconducting bulk body, and
    wherein at least one of the oxide superconducting bulk body forming the bulk magnet structure forms a stack in which the ring-shaped oxide superconducting bulk body and a second planar ring are alternately arranged, and the second planar ring is made of a metal.

4.  The bulk magnet structure according to any one of claims 1 to 3, wherein the inner diameter of the central oxide superconducting bulk body located at the central portion in the layered direction of the ring-shaped oxide superconducting bulk bodies is larger than the inner diameter of the ring-shaped oxide superconducting bulk body adjacent to the central oxide superconducting bulk body.

5. The bulk magnet structure according to any one of claims 1 to 4, wherein the height in the layered direction (Z-axis direction) of the ring-shaped oxide superconducting bulk body whose inner diameter is larger than the inner diameter of the adjacent ring-shaped oxide superconducting bulk body is 10 mm to 30 mm.

6. The bulk magnet structure according to any one of claims 1 to 5, wherein a columnar oxide superconducting bulk body is disposed at one of the ends in the layered direction of the bulk magnet structure.

7. The bulk magnet structure according to any one of claims 3 to 6, wherein the thickness of the ring-shaped oxide superconducting bulk body constituting the stack with the second planar ring is 10 mm or less.

8. The bulk magnet structure according to any one of claims 3 to 7, wherein a second outer circumferential reinforcing ring is provided between the oxide superconducting bulk body and the outer circumferential reinforcing ring.

9. The bulk magnet structure according to any one of claims 3 to 8, wherein an inner circumferential reinforcing ring is provided inside the ring-shaped oxide superconducting bulk body, and a second inner circumferential reinforcing ring is provided between the ring-shaped oxide superconducting bulk body and the inner circumferential reinforcing ring.

10. The bulk magnet structure according to any one of claims 1 to 9, wherein the oxide superconducting bulk body comprises an oxide having a structure in which $RE_2BaCuO_5$ is dispersed in a monocrystalline $REBa_2Cu_3O_y$, wherein RE is one or two or more elements selected from rare earth elements, and $6.8 \le y \le 7.1$.

11. A magnetization method for a bulk magnet structure, wherein the bulk magnet structure comprises at least one ring-shaped oxide superconducting bulk body and is configured by layering a ring-shaped oxide superconducting bulk body or a columnar oxide superconducting bulk body,

the method comprises a basic magnetization step in which, in a state where the superconducting state of the bulk magnet structure is maintained by a temperature controller for adjusting a temperature of the bulk magnet structure and a magnetic field generator for applying a magnetic field to the bulk magnet structure, the strength of the applied magnetic field applied to the bulk magnet structure is decreased by the magnetic field generator, and

after the basic magnetization step, the bulk magnet magnetic structure is magnetized by controlling at least one of the temperature controller or the magnetic field generator so that the magnetic field distribution of at least a partial region in the axial direction of the bulk magnet structure forms a magnetic field uniformization region having more uniform magnetic field distribution than the applied magnetic field distribution before magnetization.

12. The magnetization method for a bulk magnet structure according to claim 11, wherein it comprise, after the basic magnetization step, a first temperature adjustment step in which the temperature of the bulk magnet structure is maintained or raised to a predetermined temperature to improve the uniformity of the magnetic field distribution in the magnetic field uniformization region, and after the first temperature adjustment step, a second temperature adjustment step in which the temperature of the bulk magnet structure is lowered.

13. The magnetization method for a bulk magnet structure according to claim 12, wherein the applied magnetic field distribution in the axial direction of the bulk magnet structure before magnetization by the magnetic field generator is upwardly convex or downwardly convex at the central portion of the magnetic field, and, wherein in the first temperature adjustment step, the superconducting current distribution of the ring-shaped oxide superconducting bulk body located at the central portion of the bulk magnet structure is changed.

14. The magnetization method for a bulk magnet structure according to claim 13, wherein in the first temperature adjustment step, the ring-shaped oxide superconducting bulk body located at the central portion of the bulk magnet structure is brought into a fully magnetized state in which a superconducting current flows through the entire ring-shaped oxide superconducting bulk body.

15. A magnet system for NMR comprising

the bulk magnet structures according to any one of claims 1 to 10 housed in a vacuum vessel,
a cooling device for cooling the bulk magnet structure, and
a temperature controller for adjusting a temperature of the bulk magnet structure.

EP 3 492 941 A1

# FIG. 1

Z(axial direction)

7

5

7

1

10

50

21

23

20

Cooling Device

30

Temperature Controller

FIG. 2

# FIG. 3A

# FIG. 3B

# FIG. 4

Axial direction (Z)

70

72

72

72

72

Radial direction(r)

# FIG. 5A

□ : Region not flowing superconducting current

▨ : Region flowing superconducting current

Magnetization Condition 1: T=Ts, $B_a = B_1$

Superconducting current
distribution in
cross-section of bulk
magnet

Jc distribution in
cross-section of bulk
magnet
  Jc(A/m2)

Magnetic field
distribution
  B(T)

non-fully
magnetized
state

<State A>    <State B>    <State C>

EP 3 492 941 A1

# FIG. 5B

☐ : Region not flowing superconducting current

▨ : Region flowing superconducting current

Magnetization Condition 2:T=Th(Th>Ts), $B_a=B_1$

Superconducting current
distribution in
cross-section of bulk
magnet

72    z    72     r

72b   72a   z   72a    72b   r

72b   z   72b    r

Jc distribution in
cross-section of bulk
magnet
   Jc(A/m2)

Jc    r

Jc(Th)    r

Jc(Th)    r

Fully
magnetized
state

Magnetic field
distribution
   B(T)

B1 ··········    B    r

r

r

<State A>       <State B>       <State C>

EP 3 492 941 A1

# FIG. 5C

☐ :Region not flowing superconducting current

▨ :Region flowing superconducting current

Magnetization Condition 3:$T=Ts, B_a=B_2 (B_2>B_1)$

Superconducting current distribution in cross-section of bulk magnet

Jc distribution in cross-section of bulk magnet
Jc(A/m2)

Magnetic field distribution
B(T)

Fully magnetized state

<State A>    <State B>    <State C>

EP 3 492 941 A1

# FIG. 6

# FIG. 7

51A
72b
72a
51a 51b 51c 51d 51e 51f 51g

Z ← ⟨State A⟩

Z ← ⟨State B⟩

Z ← ⟨State C⟩

Temperature
higher

State A

State B

State C

State D

Magnetic field strength(T)

Position on axis (mm)

# FIG. 8

# FIG. 9

# FIG. 10

100

112(110)

122(120)

114(110)

124(120)

116(110)

130

# FIG. 11A

# FIG. 11B

# FIG. 11C

# FIG. 11D

# FIG. 12

300

321(320)

312(310)

323(320)

314(310)

325(320)

316(310)

327(320)

330

# FIG. 13

FIG. 14A

500

521(520)

512(510)

542(540)

523(520)

514(510)

544(540)

525(520)

530

# FIG. 14B

# FIG. 14C

## FIG. 14D

## FIG. 14E

# FIG. 15A

6411(6410)
6412
6413
6414
6416

611(610)

612

613

614

616

6300

6400

O

621(620)
6311(6310)
622
6312
623
6313
624
6314
626
6316
626

# FIG. 15B

6411(6410)
6412
6413
6414
6416

611(610)

612

613

614

616

6300

621(620)
6311(6310)
622
6312
623
6313
624
6314
626
6316
626

O

## FIG. 15C

# FIG. 16

Fluctuation of c-axis

c-axis

b-axis

a-axis

610

# FIG. 17A

FIG. 17B

FIG. 17C

# FIG. 17D

# FIG. 18

Line A: Magnetic field distribution after magnetization at 30K
Line B: Magnetic field distribution after temperature rise to 60K
Line C:Magnetic field distribution 1 hour after temperature rise to 60K
Line D:Magnetic field distribution after cooling to 30K

# FIG. 19

# FIG. 20A

FIG. 20B

# FIG. 21A

FIG. 21B

EP 3 492 941 A1

# FIG. 21C

EP 3 492 941 A1

Z(axial
direction)

1B

5

7

7

10B

50F

21

23

20

Cooling Device

30

Temperature
Controller

**INTERNATIONAL SEARCH REPORT**

| International application No. |
| --- |
| PCT/JP2017/027348 |

A. CLASSIFICATION OF SUBJECT MATTER
*G01R33/387*(2006.01)i, *G01R33/3815*(2006.01)i, *H01F6/00*(2006.01)i, *H01F6/04*(2006.01)i, *H01F13/00*(2006.01)i

According to International Patent Classification (IPC) or to both national classification and IPC

B. FIELDS SEARCHED

Minimum documentation searched (classification system followed by classification symbols)
G01R33/20-33/64, H01F6/00, H01F6/04, H01F13/00

Documentation searched other than minimum documentation to the extent that such documents are included in the fields searched
Jitsuyo Shinan Koho        1922-1996    Jitsuyo Shinan Toroku Koho    1996-2017
Kokai Jitsuyo Shinan Koho  1971-2017    Toroku Jitsuyo Shinan Koho    1994-2017

Electronic data base consulted during the international search (name of data base and, where practicable, search terms used)
JSTPlus/JMEDPlus/JST7580(JDreamIII)

C. DOCUMENTS CONSIDERED TO BE RELEVANT

| Category* | Citation of document, with indication, where appropriate, of the relevant passages | Relevant to claim No. |
| --- | --- | --- |
| X<br>Y | JP 2014-53479 A  (Aisin Seiki Co., Ltd.),<br>20 March 2014 (20.03.2014),<br>paragraphs [0035] to [0079]<br>(Family: none) | 1,4-9,15<br>2-3,10-14 |
| Y | JP 2012-23160 A  (Railway Technical Research Institute),<br>02 February 2012 (02.02.2012),<br>paragraphs [0012] to [0019]<br>(Family: none) | 2,10-14 |

| ☒  Further documents are listed in the continuation of Box C. | ☐  See patent family annex. |
| --- | --- |

| * | Special categories of cited documents: |
| --- | --- |
| "A" | document defining the general state of the art which is not considered    to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>29 August 2017 (29.08.17) | Date of mailing of the international search report<br>12 September 2017 (12.09.17) |
| --- | --- |
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (January 2015)

# EP 3 492 941 A1

## INTERNATIONAL SEARCH REPORT

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2002-6021 A (The Institute of Physical and Chemical Research), 09 January 2002 (09.01.2002), paragraph [0033] & US 2002/0000806 A1 paragraph [0044] & GB 2369438 A    & DE 10130678 A1 | 3,10-14 |
| Y | JP 2009-156719 A (Imura Material R&D Co., Ltd.), 16 July 2009 (16.07.2009), paragraphs [0040] to [0068] (Family: none) | 10-14 |
| Y | JP 2002-8917 A (The Institute of Physical and Chemical Research), 11 January 2002 (11.01.2002), paragraphs [0016] to [0040] & US 2002/0000807 A1 paragraphs [0024] to [0041] & GB 2367949 A    & DE 10130677 A1 | 11-14 |
| A | US 2010/0219833 A1 (MCGINLEY et al.), 02 September 2010 (02.09.2010), & WO 2009/013478 A1    & EP 2179300 A1 | 1-15 |

Form PCT/ISA/210 (continuation of second sheet) (January 2015)

# EP 3 492 941 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2002006021 A
- JP 2007129158 A
- JP 2008034692 A
- JP 2009156719 A
- JP 2014053479 A
- JP 2016006825 A
- JP 11335120 A
- JP 11284238 A
- JP 10310497 A
- JP 2014075522 A
- WO 2011071071 A
- JP 2014146760 A
- JP 6090557 B

### Non-patent literature cited in the description

- **TAKASHI NAKAMURA et al.** *Low Temperature Engineering,* 2011, vol. 46 (3
- **HIROYUKI FUJISHIRO et al.** *Supercond. Sci. Technol.,* 2015, vol. 28, 095018